# EUROPEAN PATENT APPLICATION

(11) **EP 4 716 400 A1**
(43) Date of publication of application: **25.03.2026**
(21) Application number: 25195588.6
(22) Date of filing: 13.08.2025
(51) Int. Cl.: H10B 41/41, G11C 16/08, H10B 43/40, G11C 8/12, G11C 16/04

(54) **SEMICONDUCTOR MEMORY DEVICE**

(30) Priority: 20.09.2024 JP 2024163208
(71) Applicant: Kioxia Corporation, Tokyo 108-0023 (JP)
(72) Inventor: OKADA, Nobuaki, Minato-ku, Tokyo, 108-0023 (JP); KATO, Koji, Minato-ku, Tokyo, 108-0023 (JP); SATO, Manabu, Minato-ku, Tokyo, 108-0023 (JP); OZAWA, Toru, Kanagawa, 247-8585 (JP); WATANABE, Toshifumi, Kanagawa, 247-8585 (JP); MATOBA, Kenichi, Kanagawa, 247-8585 (JP)
(74) Representative: Hoffmann Eitle

(57) **Abstract**

A semiconductor memory device comprises a first wiring layer and a second wiring layer. The second wiring layer comprises a plurality of word line voltage supply line groups and a plurality of block select line groups that are arranged alternately in a second direction. The plurality of block select line groups each include a first block select line and a second block select line. The first block select line, which is a first block select line counting from one side in the second direction, of a plurality of block select lines, comprises a first bent portion where the first block select line is bent in a direction of getting further away from a word line voltage supply line adjacent in the second direction. The second block select line comprises a first connecting portion which is electrically connected at its end portion in the first direction to the first wiring layer.

## Description

### BACKGROUND

### Field

The present embodiments relate to semiconductor memory devices.

### Description of the Related Art

There is known a semiconductor memory device comprising: a substrate; a plurality of conductive layers stacked in a direction intersecting a surface of the substrate; a semiconductor layer facing the plurality of conductive layers; and a gate insulating layer provided between the conductive layers and the semiconductor layer. The gate insulating layer comprises a memory portion capable of storing data, such as an insulative electric charge accumulating layer of silicon nitride (SiN), or the like, or a conductive electric charge accumulating layer of the likes of a floating gate, for example.

### BRIEF DESCRIPTION OF THE DRAWINGS

FIG. 1 is a schematic circuit diagram showing a part of a configuration of a memory die MD;
FIG. 2 is a schematic circuit diagram showing a part of a configuration of a peripheral circuit PC;
FIG. 3 is a schematic circuit diagram showing a part of a configuration of the peripheral circuit PC;
FIG. 4 is a schematic circuit diagram showing a part of a configuration of the peripheral circuit PC;
FIG. 5 is a schematic exploded perspective view showing a configuration example of a semiconductor memory device according to a first embodiment;
FIG. 6 is a schematic bottom view showing a configuration example of a chip C_{M};
FIG. 7 is a schematic cross-sectional view showing a part of a configuration of the memory die MD;
FIG. 8 is a schematic cross-sectional view showing a part of a configuration of the memory die MD;
FIG. 9 is a schematic bottom view showing a part of a configuration of the chip C_{M};
FIG. 10 is a schematic cross-sectional view showing a part of a configuration of the chip C_{M};
FIG. 11 is a schematic plan view showing a configuration example of a chip C_{P};
FIG. 12 is a schematic plan view showing a configuration example of a word line switch WLSW;
FIG. 13 is a schematic enlarged view of the portion indicated by B in FIG. 11;
FIG. 14 is a view showing one example of a wiring pattern of block select lines BLKSEL in a wiring layer D4;
FIG. 15 is a view showing one example of a wiring pattern of the block select lines BLKSEL in a wiring layer D3;
FIG. 16 is a view showing one example of a wiring pattern of block select lines BLKSEL, and so on, in a wiring layer D4 according to a second embodiment;
FIG. 17 is a schematic plan view showing a configuration example of part of a chip C_{P} according to a third embodiment;
FIG. 18 is a view for explaining a configuration example of parts of a chip C_{M} and a chip C_{P} according to a fourth embodiment;
FIG. 19 is a view showing one example of a wiring pattern of block select lines BLKSEL in a wiring layer D4 according to the fourth embodiment;
FIG. 20 is a schematic view showing a positional relationship of the word line switches WLSW and memory blocks BLK according to the first embodiment;
FIG. 21 is a schematic view showing a positional relationship of the word line switches WLSW and the memory blocks BLK according to another embodiment; and
FIG. 22 is a schematic view showing a positional relationship of the word line switches WLSW and the memory blocks BLK according to another embodiment.

### DETAILED DESCRIPTION

A semiconductor memory device according to one embodiment comprises: a first chip which comprises a plurality of memory blocks that are arranged in a first direction and extend in a second direction intersecting the first direction; and a second chip which is bonded to the first chip via a bonding electrode. The plurality of memory blocks each comprise: a plurality of word line conductive layers stacked in a stacking direction; a semiconductor column which extends in the stacking direction and faces the plurality of word line conductive layers; and an electric charge accumulating film provided between the plurality of word line conductive layers and the semiconductor column. The second chip comprises: a semiconductor substrate; a plurality of transistor groups which are provided on the semiconductor substrate correspondingly to the plurality of memory blocks, are arranged in the first direction, and each include a plurality of transistors arranged in the second direction; a block decoder which is provided on the semiconductor substrate, and decodes a block address to select one of the plurality of memory blocks; a first wiring layer provided between the semiconductor substrate and the first chip; and a second wiring layer provided between the first wiring layer and the first chip. The second wiring layer comprises a plurality of word line voltage supply line groups and a plurality of block select line groups that are arranged alternately in the second direction. The plurality of word line voltage supply line groups each comprise a plurality of word line voltage supply lines which extend in the first direction and are arranged in the second direction. The plurality of word line voltage supply lines are each commonly electrically connected to corresponding ones of the plurality of word line conductive layers included in each of the plurality of memory blocks, via a corresponding one of the plurality of transistors included in each of the plurality of transistor groups. The plurality of block select line groups each comprise a plurality of block select lines which extend in the first direction from a position in the first direction corresponding to the block decoder to a position in the first direction corresponding to a corresponding one of the plurality of transistor groups, and which are arranged in the second direction. The plurality of block select lines are each commonly electrically connected to gate electrodes of n transistors included in a corresponding one of the plurality of transistor groups. The plurality of block select line groups each include a first block select line and a second block select line.

The first block select line, which is a first block select line counting from one side in the second direction, of the plurality of block select lines, comprises a first bent portion where the first block select line is bent in a direction of getting further away from the word line voltage supply line adjacent in the second direction. The second block select line comprises a first connecting portion which is electrically connected at its end portion in the first direction to the first wiring layer. Positions in the first direction of the first bent portions in each of the plurality of block select line groups, differ from each other.

Next, semiconductor memory devices according to embodiments will be described in detail with reference to the drawings. Note that the following embodiments are merely examples, and are not shown with the intention of limiting the present invention. Moreover, the following drawings are schematic, and, for convenience of description, a part of a configuration, and so on, thereof will sometimes be omitted. Moreover, portions that are common to a plurality of embodiments will be assigned with the same symbols, and descriptions thereof sometimes omitted.

Moreover, when a "semiconductor memory device" is referred to in the present specification, it will sometimes mean a memory die, and will sometimes mean a memory system including a controller die, of the likes of a memory chip, a memory card, or an SSD (Solid State Drive). Furthermore, it will sometimes mean a configuration including a host computer, of the likes of a smartphone, a tablet terminal, or a personal computer.

Moreover, in the present specification, when a first configuration is said to be "electrically connected" to a second configuration, the first configuration may be connected to the second configuration directly, or the first configuration may be connected to the second configuration via the likes of a wiring, a semiconductor member, or a transistor. For example, in the case of three transistors having been connected in series, the first transistor is still "electrically connected" to the third transistor even when the second transistor is in an OFF state.

Moreover, in the present specification, when a first configuration is said to be "connected between" a second configuration and a third configuration, it will sometimes mean that the first configuration, the second configuration, and the third configuration are connected in series, and the second configuration is connected to the third configuration via the first configuration.

Moreover, in the present specification, when a circuit, or the like, is said to "make electrically continuous" two wirings, or the like, this will sometimes mean, for example, that this circuit, or the like, includes a transistor, or the like, that this transistor, or the like, is provided in a current path between the two wirings, and that this transistor, or the like, is in an ON state.

Moreover, in the present specification, a certain direction parallel to an upper surface of a substrate will be referred to as an X-direction, a direction parallel to the upper surface of the substrate and perpendicular to the X-direction will be referred to as a Y-direction, and a direction perpendicular to the upper surface of the substrate will be referred to as a Z-direction.

Moreover, in the present specification, a direction lying along a certain plane will sometimes be referred to as a first direction, a direction intersecting the first direction along the certain plane will sometimes be referred to as a second direction, and a direction intersecting the certain plane will sometimes be referred to as a third direction. These first direction, second direction, and third direction may correspond to any of the X-direction, the Y-direction, and the Z-direction, but need not do so.

Moreover, in the present specification, expressions such as "above" or "below" will be defined with reference to the substrate. For example, an orientation of moving away from the substrate along the above-described Z-direction will be referred to as above, and an orientation of coming closer to the substrate along the Z-direction will be referred to as below. Moreover, when a lower surface or a lower end is referred to for a certain configuration, this will be assumed to mean a surface or end portion on a substrate side of this configuration, and when an upper surface or an upper end is referred to for a certain configuration, this will be assumed to mean a surface or end portion on an opposite side to the substrate of this configuration. Moreover, a surface intersecting the X-direction or the Y-direction will be referred to as a side surface, and so on.

Moreover, in the present specification, when the likes of a "width", a "length", or a "thickness" in a certain direction is referred to for a configuration, a member, and so on, this will sometimes mean a width, a length, or a thickness, and so on, in a cross section observed by the likes of SEM (Scanning Electron Microscopy) or TEM (Transmission Electron Microscopy), and so on.

Moreover, in the present specification, when a "wiring" is referred to, this will sometimes include the likes of a wiring, a contact electrode, a connecting portion for connecting a wiring and a contact electrode, or a bonding electrode.

### [First Embodiment]

### [Circuit Configuration of Memory Die MD]

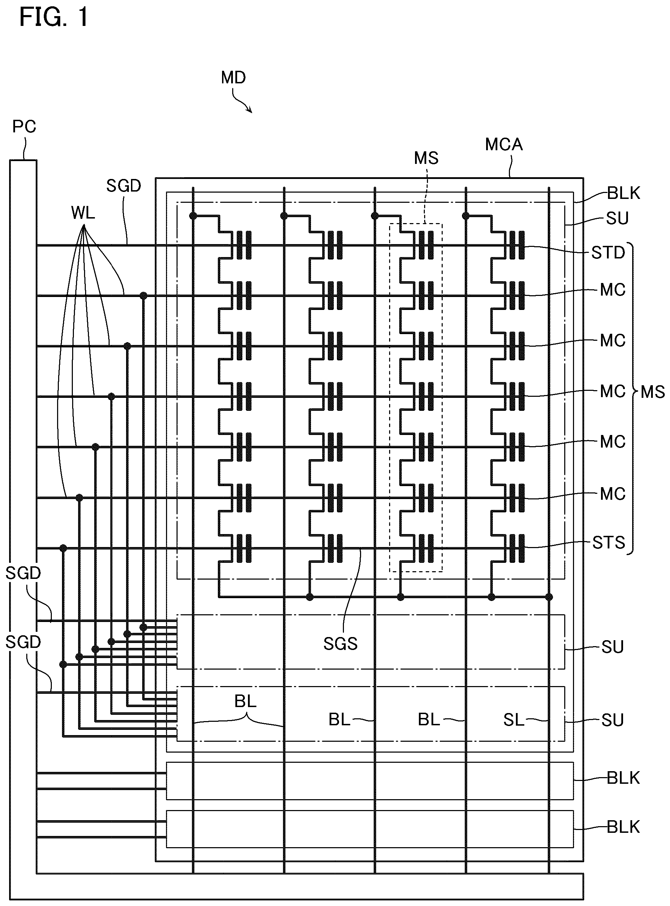

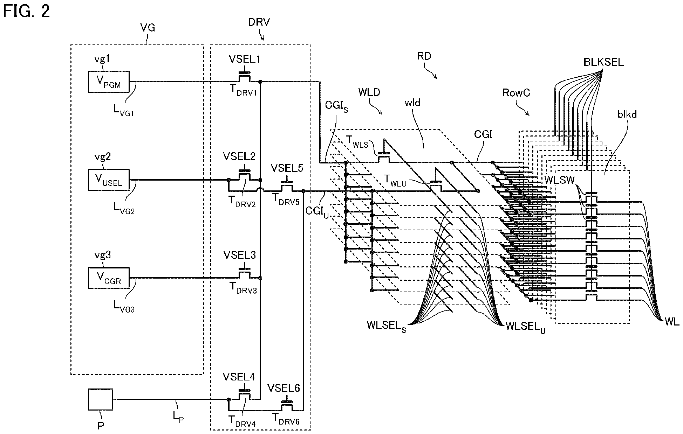

FIG. 1 is a schematic circuit diagram showing a part of a configuration of a memory die MD. FIGS. 2 to 4 are schematic circuit diagrams showing a part of a configuration of a peripheral circuit PC.

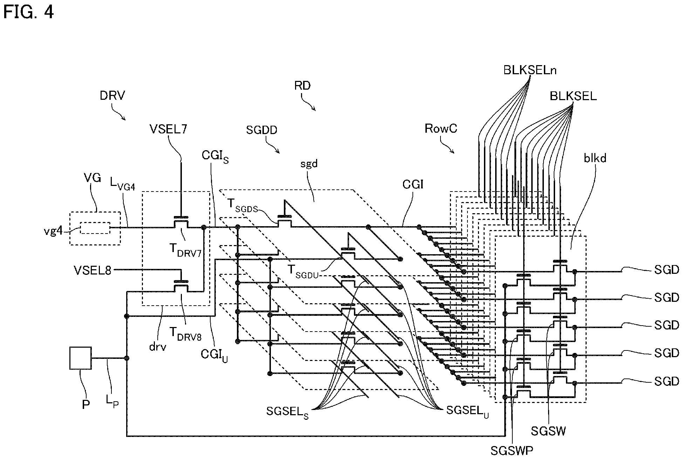

As shown in FIG. 1, the memory die MD comprises a memory cell array MCA and the peripheral circuit PC. As shown in FIGS. 2 and 4, the peripheral circuit PC comprises a voltage generating circuit VG and a row decoder RD.

### [Circuit Configuration of Memory Cell Array MCA]

As shown in FIG. 1, the memory cell array MCA comprises a plurality of memory blocks BLK. These plurality of memory blocks BLK each comprise a plurality of string units SU. These plurality of string units SU each comprise a plurality of memory strings MS. These plurality of memory strings MS have one ends each connected to the peripheral circuit PC via bit lines BL. Moreover, the other ends of these plurality of memory strings MS are each connected to the peripheral circuit PC via a common source line SL.

The memory string MS comprises a drain side select transistor STD, a plurality of memory cells MC (memory transistors), and a source side select transistor STS. The drain side select transistor STD, the plurality of memory cells MC, and the source side select transistor STS are connected in series between the bit line BL and the source line SL. Hereafter, the drain side select transistor STD and the source side select transistor STS will sometimes simply be referred to as select transistors (STD, STS).

The memory cell MC is a field effect type transistor. The memory cell MC comprises a semiconductor layer, a gate insulating film, and a gate electrode. The semiconductor layer functions as a channel region. The gate insulating film includes an electric charge accumulating film. A threshold voltage of the memory cell MC changes according to an amount of charge in the electric charge accumulating film. The memory cell MC stores 1 bit or a plurality of bits of data. Note that the gate electrodes of the plurality of memory cells MC corresponding to one memory string MS are connected with respective word lines WL. These respective word lines WL are commonly connected to all of the memory strings MS in one memory block BLK.

The select transistors (STD, STS) are field effect type transistors. The select transistors (STD, STS) each comprise a semiconductor layer, a gate insulating film, and a gate electrode. The semiconductor layer functions as a channel region. The gate insulating film may include an electric charge accumulating film. The gate electrode of the drain side select transistor STD is connected with a drain side select gate line SGD, and the gate electrode of the source side select transistor STS is connected with a source side select gate line SGS. One drain side select gate line SGD is commonly connected to all of the memory strings MS in one string unit SU. One source side select gate line SGS is commonly connected to all of the memory strings MS in one memory block BLK.

### [Circuit Configuration of Voltage Generating Circuit VG]

As shown in FIGS. 2 and 4, for example, the voltage generating circuit VG comprises a plurality of voltage generating units vg1-vg4.

The voltage generating units vg1-vg3 (FIG. 2) generate voltages of certain magnitudes and output the generated voltages via voltage supply lines L_{VG1}-L_{VG3} in a read operation, a write operation, and an erase operation. For example, the voltage generating unit vg1 outputs a program voltage V_{PGM} in the write operation. Moreover, the voltage generating unit vg2 outputs a read pass voltage in the read operation. In addition, the voltage generating unit vg2 outputs a write pass voltage V_{USEL} in the write operation. Moreover, the voltage generating unit vg3 outputs a read voltage in the read operation. In addition, the voltage generating unit vg3 outputs a verify voltage V_{CGR} in the write operation.

The voltage generating unit vg4 (FIG. 4) generates a voltage of a certain magnitude and outputs the generated voltage via a voltage supply line L_{VG4}. For example, the voltage generating circuit vg4 outputs a voltage for setting the drain side select gate line SGD to an ON state.

The voltage generating units vg1-vg3 may be a booster circuit such as a charge pump circuit, or may be a step-down circuit such as a regulator, for example. These step-down circuit and booster circuit are each connected to a voltage supply line L_{P}. The voltage supply line L_{P} is applied with a ground voltage V_{SS}. These voltage supply lines L_{P} are connected to a pad electrode P, for example. An operation voltage outputted from the voltage generating circuit VG is appropriately adjusted according to a control signal from an unillustrated sequencer.

Note that FIG. 2 exemplifies a configuration for generating a program voltage, a read pass voltage, a write pass voltage, a read voltage, and a verify voltage to be applied to the word line WL via a voltage supply line CGI in the voltage generating circuit VG. Moreover, FIG. 4 exemplifies a configuration for generating a voltage to be applied to the drain side select gate line SGD via the voltage supply line CGI in the voltage generating circuit VG. However, the voltage generating circuit VG includes a configuration for generating and outputting to a plurality of voltage supply lines a plurality of types of operation voltages to be applied to the bit line BL, the source line SL, and the select gate lines (SGD, SGS) during the read operation, the write operation, and an erase operation on the memory cell array MCA, not only operation voltages to be applied to the word line WL and the drain side select gate line SGD. These operation voltages are appropriately adjusted according to a control signal from the unillustrated sequencer.

### [Circuit Configuration of Row Decoder RD]

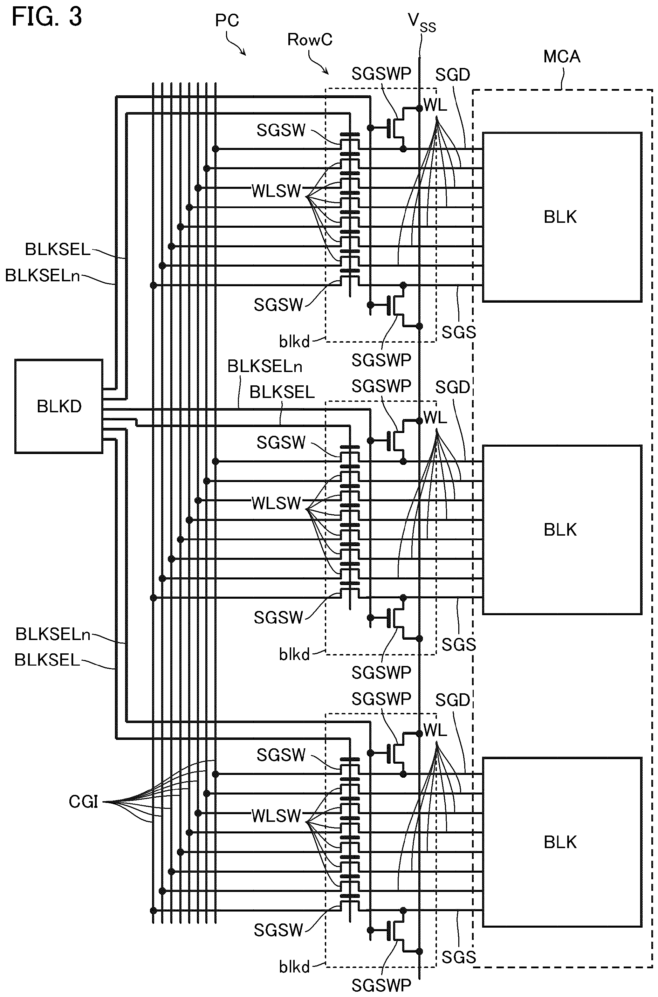

As shown in FIGS. 2 and 4, for example, the row decoder RD comprises a row control circuit RowC, a word line decoder WLD, a select gate line decoder SGDD, a driver circuit DRV, and an unillustrated address decoder. As shown in FIG. 3, for example, the row control circuit RowC comprises a plurality of block decoder units blkd and a block decoder BLKD.

The plurality of block decoder units blkd correspond to the plurality of memory blocks BLK in the memory cell array MCA. The block decoder unit blkd comprises a plurality of word line switches WLSW and a plurality of select gate line switches SGSW, SGSWP. The plurality of word line switches WLSW correspond to the plurality of word lines WL in the memory block BLK. The plurality of select gate line switches SGSW, SGSWP correspond to the drain side select gate line SGD and the source side select gate line SGS in the memory block BLK.

The word line switch WLSW is a field effect type NMOS transistor, for example. A drain electrode of the word line switch WLSW is connected to the word line WL. A source electrode of the word line switch WLSW is connected to the voltage supply line CGI. A gate electrode of the word line switch WLSW is connected to a block select line BLKSEL.

The select gate line switch SGSW is a field effect type NMOS transistor, for example. A drain electrode of the select gate line switch SGSW is connected to the drain side select gate line SGD and the source side select gate line SGS. A source electrode of the select gate line switch SGSW is connected to the voltage supply line CGI. A gate electrode of the select gate line switch SGSW is connected to the block select line BLKSEL.

The select gate line switch SGSWP is a field effect type NMOS transistor, for example. A drain electrode of the select gate line switch SGSWP is connected to the drain side select gate line SGD and the source side select gate line SGS. A source electrode of the select gate line switch SGSWP is connected to the pad electrode P. A gate electrode of the select gate line switch SGSWP is connected to a block select line BLKSELn.

A plurality of the block select lines BLKSEL, BLKSELn are provided correspondingly to all of the block decoder units blkd. Moreover, the block select lines BLKSEL, BLKSELn are connected to all of the word line switches WLSW and the select gate line switches SGSW in the block decoder unit blkd.

The block decoder BLKD (FIG. 3) decodes a block address, and thereby applies an H state voltage to the one block select line BLKSEL corresponding to the block address, and an L state voltage to the one block select line BLKSELn corresponding to this one block select line BLKSEL. In addition, the block decoder BLKD thereby applies the L state voltage to other block select lines BLKSEL, and the H state voltage to the plurality of block select lines BLKSELn corresponding to these other block select lines BLKSEL.

The word line decoder WLD (FIG. 2) comprises a plurality of word line decode units wld. The plurality of word line decode units wld each correspond to the plurality of memory cells MC in the memory string MS. In the example of FIG. 2, the word line decode unit wld comprises two transistors T_{WLS}, T_{WLU}. The transistors T_{WLS}, T_{WLU} are each a field effect type NMOS transistor, for example. Drain electrodes of the transistors T_{WLS}, T_{WLU} are connected to the voltage supply line CGI. A source electrode of the transistor T_{WLS} is connected to a voltage supply line CGI_{S}. A source electrode of the transistor T_{WLU} is connected to a voltage supply line CGI_{U}. A gate electrode of the transistor T_{WLS} is connected to a signal line WLSEL_{S}. A gate electrode of the transistor T_{WLU} is connected to a signal line WLSEL_{U}. A plurality of the signal lines WLSEL_{S} are provided correspondingly to the transistors T_{WLS} being ones of the pairs of transistors T_{WLS}, T_{WLU}, included in all of the word line decode units wld. A plurality of the signal lines WLSEL_{U} are provided correspondingly to the transistors T_{WLU} being the others of the pairs of transistors T_{WLS}, T_{WLU}, included in all of the word line decode units wld.

In the read operation, the write operation, and so on, for example, the signal line WLSEL_{S} corresponding to one word line decode unit wld corresponding to a page address attains the "H" state, and the signal line WLSEL_{U} corresponding to this signal line WLSEL_{S} attains the "L" state. Moreover, the signal lines WLSEL_{S} corresponding to other word line decode units wld attain the "L" state, and the signal lines WLSEL_{U} corresponding to these signal lines WLSEL_{S} attain the "H" state. Moreover, the voltage supply line CGI_{S} is applied with a voltage corresponding to a selected word line WL. Moreover, the voltage supply line CGI_{U} is applied with a voltage corresponding to an unselected word line WL.

The select gate line decoder SGDD (FIG. 4) comprises a plurality of select gate line decode units sgd. The plurality of select gate line decode units sgd correspond to the plurality of string units SU in the memory block BLK. In the example of FIG. 4, the select gate line decode unit sgd comprises two transistors T_{SGDS}, T_{SGDU}. The transistors T_{SGDS}, T_{SGDU} are each a field effect type NMOS transistor, for example. Drain electrodes of the transistors T_{SGDS}, T_{SGDU} are connected to the voltage supply line CGI. A source electrode of the transistor T_{SGDS} is connected to the voltage supply line CGI_{S}. A source electrode of the transistor T_{SGDU} is connected to the voltage supply line CGI_{U}. A gate electrode of the transistor T_{SGDS} is connected to a signal line SGSEL_{S}. A gate electrode of the transistor T_{SGDU} is connected to a signal line SGSEL_{U}. A plurality of the signal lines SGSEL_{S} are provided correspondingly to the transistors T_{SGDS} being ones of the pairs of transistors T_{SGDS}, T_{SGDU}, included in all of the select gate line decode units sgd. A plurality of the signal lines SGSEL_{U} are provided correspondingly to the transistors T_{SGDU} being the others of the pairs of transistors T_{SGDS}, T_{SGDU}, included in all of the select gate line decode units sgd.

In the read operation, the write operation, and so on, for example, the signal line SGSEL_{S} corresponding to one select gate line decode unit sgd corresponding to a page address attains the "H" state, and the signal line SGSEL_{U} corresponding to this signal line SGSEL_{S} attains the "L" state. Moreover, the signal lines SGSEL_{S} corresponding to other select gate line decode units sgd attain the "L" state, and the signal lines SGSEL_{U} corresponding to these signal lines SGSEL_{S} attain the "H" state. Moreover, the voltage supply line CGI_{S} is applied with a voltage corresponding to the drain side select gate line SGD in a selected string unit SU. Moreover, the voltage supply line CGI_{U} is applied with a voltage corresponding to the drain side select gate line SGD in an unselected string unit SU.

The driver circuit DRV comprises transistors T_{DRV1}-T_{DRV6}, as shown in FIG. 2, for example. The transistors T_{DRV1}-T_{DRV6} are each a field effect type NMOS transistor, for example. Drain electrodes of the transistors T_{DRV1}-T_{DRV4} are connected to the voltage supply line CGI_{S}. Drain electrodes of the transistors T_{DRV5}, T_{DRV6} are connected to the voltage supply line CGI_{U}. A source electrode of the transistor T_{DRV1} is connected to an output terminal of the voltage generating unit vg1, via the voltage supply line L_{VG1}. Source electrodes of the transistors T_{DRV2}, T_{DRV5} are connected to an output terminal of the voltage generating unit vg2, via the voltage supply line L_{VG2}. A source electrode of the transistor T_{DRV3} is connected to an output terminal of the voltage generating unit vg3, via the voltage supply line L_{VG3}. Source electrodes of the transistors T_{DRV4}, T_{DRV6} are connected to the pad electrode P, via the voltage supply line L_{P}. Gate electrodes of the transistors T_{DRV1}-T_{DRV6} are respectively connected with signal lines VSEL1-VSEL6.

In the read operation, the write operation, and so on, for example, one of the plurality of signal lines VSEL1-VSEL4 corresponding to the voltage supply line CGI_{S} attains the "H" state, and the others attain the "L" state. Moreover, one of the two signal lines VSEL5, VSEL6 corresponding to the voltage supply line CGI_{U} attains the "H" state, and the other attains the "L" state.

In addition, the driver circuit DRV comprises transistors T_{DRV7}, T_{DRV8}, as shown in FIG. 4, for example. The transistors T_{DRV7}, T_{DRV8} are each a field effect type NMOS transistor, for example. Drain electrodes of the transistors T_{DRV7}, T_{DRV8} are connected to the voltage supply line CGI_{S}. A source electrode of the transistor T_{DRV7} is connected to an output terminal of the voltage generating unit vg4, via the voltage supply line L_{VG4}. A source electrode of the transistor T_{DRV8} is connected to the pad electrode P. Gate electrodes of the transistors T_{DRV7}, T_{DRV8} are respectively connected with signal lines VSEL7, VSEL8.

In the read operation, the write operation, and so on, for example, one of the two signal lines VSEL7, VSEL8 corresponding to the voltage supply line CGI_{S} attains the "H" state, and the other attains the "L" state.

Note that in the example of FIGS. 2 to 4, the block decoder units blkd are provided one each to each one of the memory blocks BLK in the row decoder RD. However, this configuration can be appropriately changed. For example, the block decoder units blkd may be provided one each to every two or more of the memory blocks BLK in the row decoder RD.

### [Structure of Memory Die MD]

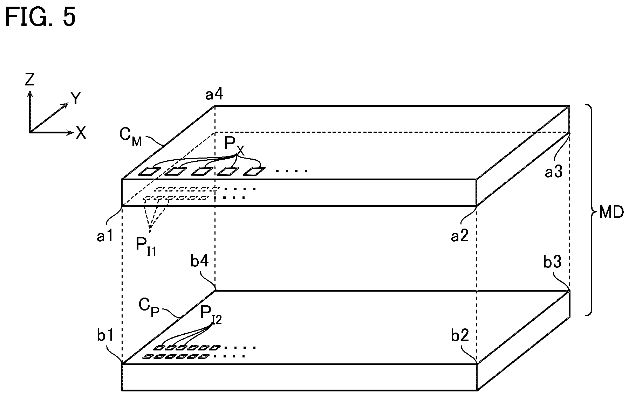

FIG. 5 is a schematic exploded perspective view showing a configuration example of a semiconductor memory device according to a first embodiment. As shown in FIG. 5, the memory die MD comprises: a chip C_{M} on a memory cell array MCA side; and a chip C_{P} on a peripheral circuit PC side.

An upper surface of the chip C_{M} is provided with a plurality of external pad electrodes P_{X} connectable to unillustrated bonding wires. Moreover, a lower surface of the chip C_{M} is provided with a plurality of bonding electrodes P_{I1}. Moreover, an upper surface of the chip C_{P} is provided with a plurality of bonding electrodes P_{I2}. Hereafter, a surface provided with the plurality of bonding electrodes P_{I1}, of the chip C_{M} will be referred to as a front surface, and a surface provided with the plurality of external pad electrodes P_{X}, of the chip C_{M} will be referred to as a back surface. Moreover, a surface provided with the plurality of bonding electrodes P_{I2}, of the chip C_{P} will be referred to as a front surface, and a surface on an opposite side to the front surface, of the chip C_{P} will be referred to as a back surface. In the example illustrated, the front surface of the chip C_{P} is provided above the back surface of the chip C_{P}, and the back surface of the chip C_{M} is provided above the front surface of the chip C_{M}.

The chip C_{M} and the chip C_{P} are disposed so that the front surface of the chip C_{M} and the front surface of the chip C_{P} face each other. The plurality of bonding electrodes P_{I1} are provided correspondingly to the respective plurality of bonding electrodes P_{I2}, and are disposed at positions enabling them to be bonded to the plurality of bonding electrodes P_{I2}. The bonding electrodes P_{I1} and the bonding electrodes P_{I2} function as bonding electrodes for bonding and making electrically continuous the chip C_{M} and the chip C_{P}.

Note that in the example of FIG. 5, corners a1, a2, a3, a4 of the chip C_{M} respectively correspond to corners b1, b2, b3, b4 of the chip C_{P}.

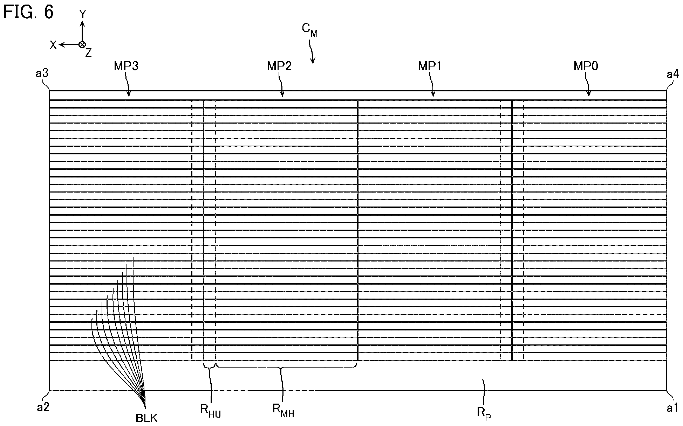

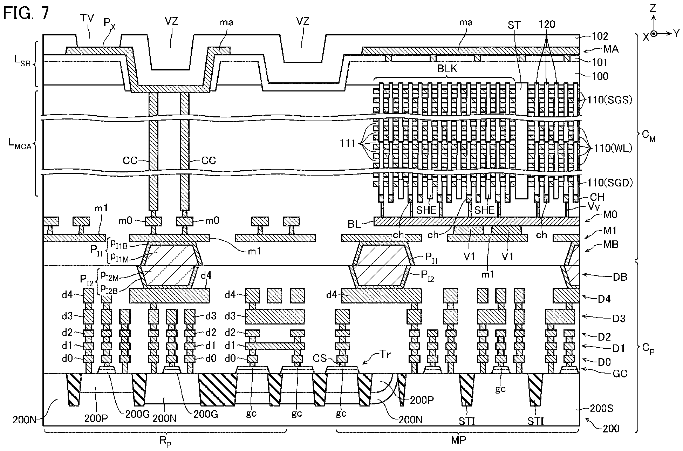

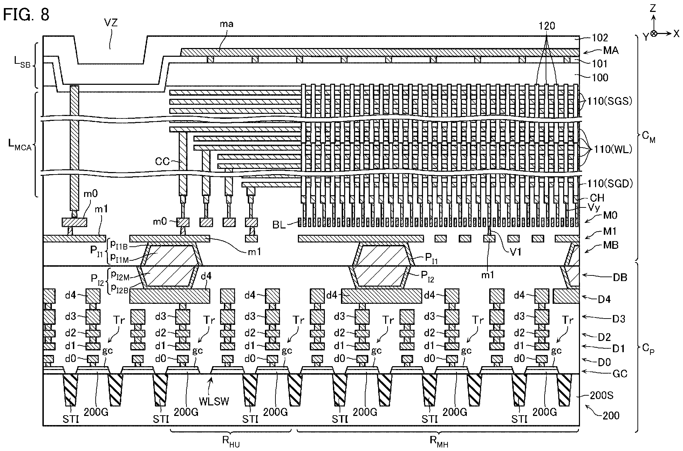

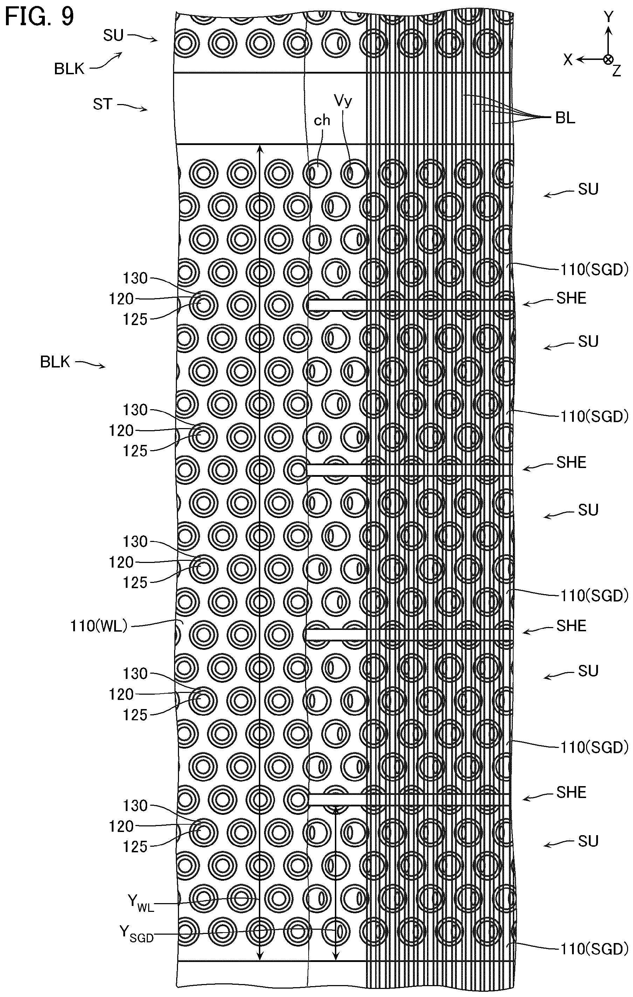

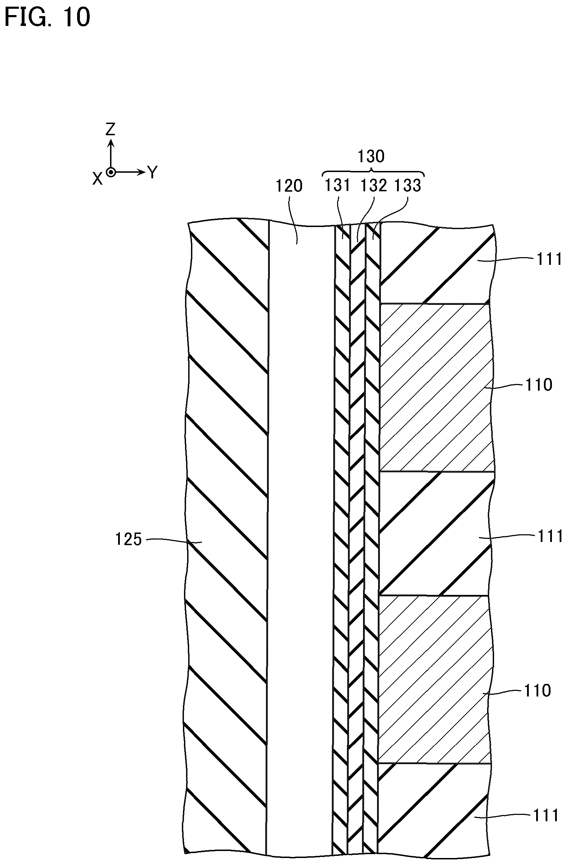

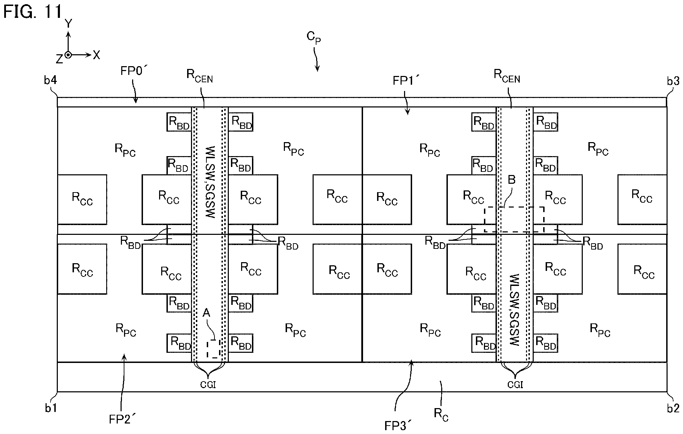

FIG. 6 is a schematic bottom view showing a configuration example of the chip C_{M}. In FIG. 6, a part of a configuration such as the bonding electrodes P_{I1} are omitted. FIGS. 7 and 8 are schematic cross-sectional views showing a part of a configuration of the memory die MD. FIG. 9 is a schematic bottom view showing a part of a configuration of the chip C_{M}. In FIG. 9, a region on the left side shows an XY cross section at a position of the word lines WL, and a region on the right side shows an XY cross section at a position of the drain side select gate line SGD. Note that in order to indicate connecting portions of semiconductor layers 120 and the bit lines BL, the region on the right side of FIG. 9 also shows contact electrodes ch, Vy and the bit lines BL. The contact electrodes ch, Vy and the bit lines BL are also provided in the region on the left side of FIG. 9. FIG. 10 is a schematic cross-sectional view showing a part of a configuration of the chip C_{M}. Although FIG. 10 shows a YZ cross section, a similar structure to in FIG. 10 will be observed, even in the case where a cross section other than a YZ cross section (for example, an XZ cross section) along a central axis of the semiconductor layer 120 has been observed. FIG. 11 is a schematic plan view showing a configuration example of the chip C_{P}. In FIG. 11, a part of a configuration such as the bonding electrodes P_{I2} are omitted.

### [Structure of Chip C_{M}]

In the example of FIG. 6, the chip C_{M} comprises four memory planes MP0-MP3 arranged in the X-direction. Note that sometimes, the four memory planes MP0-MP3 will each simply be referred to as a memory plane MP. Moreover, these four memory planes MP0-MP3 each comprise a plurality of the memory blocks BLK arranged in the Y-direction. Moreover, in the example of FIG. 6, these four memory planes MP0-MP3 each comprise: a memory hole region R_{MH} (a memory region); and a hook-up region R_{HU} provided on one side in the X-direction with respect to the memory hole region R_{MH}. Moreover, the chip C_{M} comprises a peripheral region R_{P} provided further to a side at one end in the Y-direction of the chip C_{M} than are the four memory planes MP0-MP3.

Note that in the example illustrated, the hook-up region R_{HU} is provided on one side in the X-direction with respect to the memory hole region R_{MH}. However, such a configuration is merely an exemplification, and a specific configuration may be appropriately adjusted. For example, the hook-up region R_{HU} may be provided on both sides in the X-direction with respect to the memory hole region R_{MH}. Moreover, the hook-up region R_{HU} may be provided at a center position or near center position in the X-direction of the memory plane MP.

As shown in FIG. 7, for example, the chip C_{M} comprises: a substrate layer L_{SB}; a memory cell array layer L_{MCA} provided below the substrate layer L_{SB}; a contact electrode layer CH provided below the memory cell array layer L_{MCA}; a plurality of wiring layers M0, M1 provided below the contact electrode layer CH; and a chip bonding electrode layer MB provided below the wiring layers M0, M1.

### [Structure of Substrate Layer L_{SB} of Chip C_{M}]

As shown in FIG. 7, for example, the substrate layer L_{SB} comprises: a conductive layer 100 provided on an upper surface of the memory cell array layer L_{MCA}; an insulating layer 101 provided on an upper surface of the conductive layer 100; a back surface wiring layer MA provided on an upper surface of the insulating layer 101; and an insulating layer 102 provided on an upper surface of the back surface wiring layer MA.

The conductive layer 100 may include a semiconductor layer of the likes of silicon (Si) implanted with an N-type impurity such as phosphorus (P) or P-type impurity such as boron (B), may include a metal of the likes of tungsten (W), or may include a silicide of the likes of tungsten silicide (WSi), for example.

The conductive layer 100 functions as part of the source line SL (FIG. 1). Four conductive layers 100 are provided correspondingly to the four memory planes MP0-MP3 (FIG. 6). End portions in the X-direction and Y-direction of the memory plane MP are provided with a region VZ not including the conductive layer 100.

The insulating layer 101 includes the likes of silicon oxide (SiO₂), for example.

The back surface wiring layer MA includes a plurality of wirings ma. The plurality of wirings ma may include the likes of aluminum (Al), for example.

Parts of the plurality of wirings ma function as part of the source line SL (FIG. 1). Four of these wirings ma are provided correspondingly to the four memory planes MP0-MP3 (FIG. 6). Each such wiring ma is electrically connected to the conductive layer 100.

Moreover, parts of the plurality of wirings ma function as the external pad electrode P_{X}. This wiring ma is provided in the peripheral region R_{P}. This wiring ma is connected to a contact electrode CC within the memory cell array layer L_{MCA} in the region VZ not including the conductive layer 100. Moreover, part of the wiring ma is exposed to outside of the memory die MD via an opening TV provided in the insulating layer 102.

The insulating layer 102 is a passivation layer consisting of an insulating material such as a polyimide, for example.

### [Structure in Memory Hole Region R_{MH} of Memory Cell Array Layer L_{MCA} of Chip C_{M}]

As described with reference to FIG. 6, the memory cell array layer L_{MCA} is provided with a plurality of the memory blocks BLK arranged in the Y-direction. As shown in FIG. 7, an inter-block insulating layer ST of the likes of silicon oxide (SiO₂) is provided between two memory blocks BLK adjacent in the Y-direction.

A shown in FIG. 7, for example, the memory block BLK comprises: a plurality of conductive layers 110 arranged in the Z-direction; and a plurality of the semiconductor layers 120 extending in the Z-direction. Moreover, as shown in FIG. 10, respective gate insulating films 130 are provided between the plurality of conductive layers 110 and the plurality of semiconductor layers 120.

The conductive layer 110 comprises a substantially platelike shape extending in the X-direction. The conductive layer 110 may include a stacked film having stacked therein a barrier conductive film of the likes of titanium nitride (TiN) and a metal film of the likes of tungsten (W) or molybdenum (Mo), and so on. Moreover, the conductive layer 110 may include the likes of polycrystalline silicon including an impurity such as phosphorus (P) or boron (B), for example. An inter-layer insulating layer 111 of the likes of silicon oxide (SiO₂) is provided between the plurality of conductive layers 110 arranged in the Z-direction.

One or a plurality of conductive layers 110 located in the uppermost layer, of the plurality of conductive layers 110 function as the gate electrodes of the source side select transistors STS (FIG. 1) and as the source side select gate line SGS (refer to FIG. 7). These plurality of conductive layers 110 are electrically independent every memory block BLK.

Moreover, the plurality of conductive layers 110 located below these uppermost layer-located conductive layers 110 function as the gate electrodes of the memory cells MC (FIG. 1) and as the word lines WL. These plurality of conductive layers 110 are each electrically independent every memory block BLK.

Moreover, one or a plurality of conductive layers 110 located below these word line WL-functioning conductive layers 110, function as the gate electrodes of the drain side select transistors STD and as the drain side select gate line SGD. As shown in FIG. 9, for example, width Y_{SGD} in the Y-direction of these plurality of conductive layers 110 is less than width Y_{WL} in the Y-direction of the conductive layers 110 functioning as the word lines WL. Moreover, an inter-string unit insulating layer SHE of the likes of silicon oxide (SiO₂) is provided between two conductive layers 110 adjacent in the Y-direction.

As shown in FIG. 9, for example, the semiconductor layers 120 are arranged in a certain pattern in the X-direction and the Y-direction. The semiconductor layers 120 each function as channel regions of the plurality of memory cells MC and the select transistors (STD, STS) included in one memory string MS (FIG. 1). The semiconductor layer 120 includes the likes of polycrystalline silicon (Si), for example. The semiconductor layer 120 has a substantially cylindrical shape, and has its central portion provided with an insulating layer 125 of the likes of silicon oxide. Outer peripheral surfaces of the semiconductor layers 120 are each surrounded by a plurality of the conductive layers 110, and face these plurality of conductive layers 110.

Moreover, an upper end of the semiconductor layer 120 is provided with an unillustrated impurity region. This impurity region is connected to the above-described conductive layer 100 (refer to FIG. 7). This impurity region includes an N-type impurity such as phosphorus (P) or a P-type impurity such as boron (B), for example.

Moreover, a lower end of the semiconductor layer 120 is provided with an unillustrated impurity region. This impurity region is connected to the bit line BL via the contact electrode ch and the contact electrode Vy. This impurity region includes an N-type impurity such as phosphorus (P), for example.

As shown in FIG. 9, for example, the gate insulating film 130 has a substantially cylindrical shape covering the outer peripheral surface of the semiconductor layer 120. As shown in FIG. 10, for example, the gate insulating film 130 comprises a tunnel insulating film 131, an electric charge accumulating film 132, and a block insulating film 133 that are stacked between the semiconductor layer 120 and the conductive layers 110. The tunnel insulating film 131 and the block insulating film 133 include the likes of silicon oxide (SiO₂) or silicon oxynitride (SiON), for example. The electric charge accumulating film 132 includes a film capable of accumulating a charge, of the likes of silicon nitride (SiN), for example. The tunnel insulating film 131, the electric charge accumulating film 132, and the block insulating film 133 have substantially cylindrical shapes, and extend in the Z-direction along the outer peripheral surface of the semiconductor layer 120 excluding a contact portion of the semiconductor layer 120 and the conductive layer 100.

Note that FIG. 10 has shown an example where the gate insulating film 130 comprises the electric charge accumulating film 132 of the likes of silicon nitride. However, the gate insulating film 130 may comprise a floating gate of the likes of polycrystalline silicon including an N-type or P-type impurity, for example.

### [Structure in Hook-up Region R_{HU} of Memory Cell Array Layer L_{MCA} of Chip C_{M}]

As shown in FIG. 8, the hook-up region R_{HU} is provided with a plurality of the contact electrodes CC. These plurality of contact electrodes CC each extend in the Z-direction and are connected at their upper ends to the conductive layers 110 (WL, SGD, SGS).

### [Structure in Peripheral Region R_{P} of Memory Cell Array Layer L_{MCA} of Chip C_{M}]

As shown in FIG. 7, for example, a plurality of the contact electrodes CC are provided in the peripheral region R_{P}, correspondingly to the external pad electrodes P_{X}. These plurality of contact electrodes CC are connected at their upper ends to the external pad electrode P_{X}.

### [Structure of Contact Electrode Layer CH of Chip C_{M}]

A plurality of the contact electrodes ch included in the contact electrode layer CH are electrically connected to at least one of a configuration in the memory cell array layer L_{MCA} and a configuration in the chip C_{P}, for example.

The contact electrode layer CH includes the plurality of contact electrodes ch as a plurality of wirings. These plurality of contact electrodes ch may include for example a stacked film having stacked therein a barrier conductive film of the likes of titanium nitride (TiN) and a metal film of the likes of tungsten (W), and so on. The contact electrodes ch, which are provided correspondingly to the plurality of semiconductor layers 120, are connected to the lower ends of the plurality of semiconductor layers 120.

### [Structure of Wiring Layers M0, M1 of Chip C_{M}]

A plurality of wirings included in the wiring layers M0, M1 are electrically connected to at least one of the configuration in the memory cell array layer L_{MCA} and the configuration in the chip C_{P}, for example.

The wiring layer M0 includes a plurality of wirings m0. These plurality of wirings m0 may include for example the likes of a stacked film having stacked therein: a barrier conductive film of the likes of titanium nitride (TiN), tantalum nitride (TaN), or a stacked film of tantalum nitride (TaN) and tantalum (Ta); and a metal film of the likes of copper (Cu). Note that parts of the plurality of wirings m0 function as the bit lines BL. As shown in FIG. 9, for example, the bit lines BL are arranged in the X-direction and extend in the Y-direction.

As shown in FIG. 7, for example, the wiring layer M1 includes a plurality of wirings m1. These plurality of wirings m1 may include for example a stacked film having stacked therein a barrier conductive film of the likes of titanium nitride (TiN) and a metal film of the likes of tungsten (W), and so on. Moreover, as shown in FIGS. 7 and 8, for example, these plurality of wirings m1 are electrically connected to the wiring m0 via a contact electrode V1.

### [Structure of Chip Bonding Electrode Layer MB]

A plurality of wirings included in the chip bonding electrode layer MB are electrically connected to at least one of the configuration in the memory cell array layer L_{MCA} and the configuration in the chip C_{P}, for example.

The chip bonding electrode layer MB includes a plurality of the bonding electrodes P_{I1} (bonding pads). These plurality of bonding electrodes P_{I1} may include for example the likes of a stacked film having stacked therein: a barrier conductive film P_{I1B} of the likes of titanium nitride (TiN), tantalum nitride (TaN), or a stacked film of tantalum nitride (TaN) and tantalum (Ta); and a metal film p_{I1M} of the likes of copper (Cu).

### [Structure of Chip C_{P}]

As shown in FIG. 11, for example, the chip C_{P} comprises four planes FP0'-FP3' in which two are arranged in the X-direction and two are arranged in the Y-direction, in a region overlapping the four memory planes MP0-MP3 arranged in the X-direction. Center regions R_{CEN} in the X-direction of the two planes FP0', FP2' arranged in the Y-direction and the two planes FP1', FP3' arranged in the Y-direction are each provided with the plurality of word line switches WLSW and the plurality of select gate line switches SGSW, SGSWP, and both end portions in the X-direction of these center regions R_{CEN} are provided with a plurality of the voltage supply lines CGI. Moreover, a region excluding the center region R_{CEN} in the X-direction, of the four planes FP0'-FP3' is provided with a peripheral circuit region R_{PC}.

In the peripheral circuit region R_{PC} of each of the four planes FP0'-FP3', a plurality of block decoder regions R_{BD} arranged separated from each other in the Y-direction are provided on both sides in the X-direction of the center region R_{CEN}. These plurality of block decoder regions R_{BD} are each provided with the block decoder BLKD described with reference to FIG. 3.

The block decoder regions R_{BD} close to a boundary of the two planes FP0', FP2' arranged in the Y-direction are provided at positions closely adjacent in the Y-direction. Similarly, the block decoder regions R_{BD} close to a boundary of the two planes FP1', FP3' arranged in the Y-direction are provided at positions closely adjacent in the Y-direction.

Moreover, the peripheral circuit region R_{PC} of each of the four planes FP0'-FP3' is provided with four column control circuit regions R_{CC} arranged in the X-direction. Moreover, other regions in the peripheral circuit region R_{PC} also have circuits disposed therein, although illustration of this is omitted. Moreover, a region of the chip C_{P} facing the peripheral region R_{P} (FIG. 6) of the chip C_{M} is provided with a circuit region R_{C}.

The column control circuit region R_{CC} is provided with a sense amplifier module SAM. The sense amplifier module SAM detects ON state/OFF state of a memory cell MC, and acquires data indicating a state of this memory cell MC. The sense amplifier module SAM comprises a plurality of sense amplifier units. The plurality of sense amplifier units correspond to a plurality of the bit lines BL. The plurality of sense amplifier units each comprise a sense amplifier circuit and a latch circuit.

The circuit region R_{C} is provided with an unillustrated input/output circuit. This input/output circuit is connected to the external pad electrode P_{X} via the contact electrode CC, and so on, described with reference to FIG. 7.

Moreover, as shown in FIG. 7, for example, the chip C_{P} comprises: a semiconductor substrate 200; an electrode layer GC provided above the semiconductor substrate 200; wiring layers D0, D1, D2, D3, D4 provided above the electrode layer GC; and a chip bonding electrode layer DB provided above the wiring layers D0, D1, D2, D3, D4.

### [Structure of Semiconductor Substrate 200 of Chip C_{P}]

The semiconductor substrate 200 includes P-type silicon (Si) that includes a P-type impurity such as boron (B), for example. A surface of the semiconductor substrate 200 is provided with, for example: an N-type well region 200N including an N-type impurity such as phosphorus (P); a P-type well region 200P including a P-type impurity such as boron (B); a semiconductor substrate region 200S where the N-type well region 200N and P-type well region 200P are not provided; and an insulating region STI. A part of the P-type well regions 200P are provided in the semiconductor substrate region 200S, and a part of the P-type well regions 200P are provided in the N-type well region 200N. The N-type well region 200N, the P-type well regions 200P provided in the N-type well region 200N and the semiconductor substrate region 200S, and the semiconductor substrate region 200S each function as parts of a plurality of transistors Tr and a plurality of capacitors, and so on, configuring the peripheral circuit PC. The insulating region STI includes the likes of silicon oxide (SiO₂), for example, and extends in the Z-direction.

### [Structure of Electrode Layer GC of Chip C_{P}]

The electrode layer GC is provided on an upper surface of the semiconductor substrate 200 via an insulating layer 200G. The electrode layer GC includes a plurality of electrodes gc that face the surface of the semiconductor substrate 200. Moreover, each of the regions of the semiconductor substrate 200 and the plurality of electrodes gc included in the electrode layer GC is connected to contact electrodes CS.

The respective plurality of electrodes gc included in the electrode layer GC function as gate electrodes of the plurality of transistors Tr, and so on, configuring the peripheral circuit PC.

The contact electrode CS extends in the Z-direction, and is connected at its lower end to an upper surface of the semiconductor substrate 200 or electrode gc. A connecting portion of the contact electrode CS and semiconductor substrate 200 is provided with an impurity region including an N-type impurity or P-type impurity. The contact electrode CS may include for example a stacked film having stacked therein a barrier conductive film of the likes of titanium nitride (TiN) and a metal film of the likes of tungsten (W), and so on.

### [Structure of Wiring Layers D0, D1, D2, D3, D4 of Chip C_{P}]

As shown in FIG. 7, for example, a plurality of connecting portions and a plurality of wirings included in the wiring layers D0, D1, D2, D3, D4 are electrically connected to at least one of the configuration in the memory cell array layer L_{MCA} and the configuration in the chip C_{P}, for example.

The wiring layers D0, D1, D2 respectively include pluralities of connecting portions d0, d1, d2 and pluralities of wirings. These pluralities of connecting portions d0, d1, d2 and pluralities of wirings may include for example a stacked film having stacked therein a barrier conductive film of the likes of titanium nitride (TiN) and a metal film of the likes of tungsten (W), and so on.

The wiring layers D3, D4 respectively include pluralities of connecting portions d3, d4 and pluralities of wirings. These pluralities of connecting portions d3, d4 and pluralities of wirings may include for example the likes of a stacked film having stacked therein: a barrier conductive film of the likes of titanium nitride (TiN), tantalum nitride (TaN), or a stacked film of tantalum nitride (TaN) and tantalum (Ta); and a metal film of the likes of copper (Cu).

### [Structure of Chip Bonding Electrode Layer DB]

A plurality of wirings included in the chip bonding electrode layer DB are electrically connected to at least one of the configuration in the memory cell array layer L_{MCA} and the configuration in the chip C_{P}, for example.

The chip bonding electrode layer DB includes the plurality of bonding electrodes P_{I2}. These plurality of bonding electrodes P_{I2} may include for example the likes of a stacked film having stacked therein: a barrier conductive film p_{I2B} of the likes of titanium nitride (TiN), tantalum nitride (TaN), or a stacked film of tantalum nitride (TaN) and tantalum (Ta); and a metal film p_{I2M} of the likes of copper (Cu).

Note that when the metal films p_{I1M}, p_{I2M} of the likes of copper (Cu) are employed in the bonding electrode P_{I1} and the bonding electrode P_{I2}, the metal film p_{I1M} and the metal film p_{I2M} become one metal film, so that identification of their boundary with each other becomes difficult. However, due to distortion of shape where the bonding electrode P_{I1} and the bonding electrode P_{I2} have been bonded resulting from positional shift of bonding, and due to positional shift (generation of discontinuous places in side surfaces) of the barrier conductive films p_{I1B}, p_{I2B}, bonding structure can be identified. Moreover, when the bonding electrode P_{I1} and the bonding electrode P_{I2} are formed by a damascene method, their respective side surfaces will have a tapered shape. Therefore, shape of a cross section along the Z-direction in a portion where the bonding electrode P_{I1} and the bonding electrode P_{I2} have been bonded will be non-rectangular due to side walls being nonlinearly shaped. Moreover, when the bonding electrode P_{I1} and the bonding electrode P_{I2} are bonded, there will be a structure where each of a bottom surface, side surface, and upper surface of the Cu forming them will be covered by a barrier metal. In contrast, in a general wiring layer employing Cu, the upper surface of the Cu is provided with an insulating layer (of the likes of SiN or SiCN) functioning to prevent oxidation of the Cu, and is not provided with a barrier metal. Therefore, distinction from a general wiring layer is possible, even when positional shift of bonding has not occurred.

### [Structure of Word Line Switch WLSW]

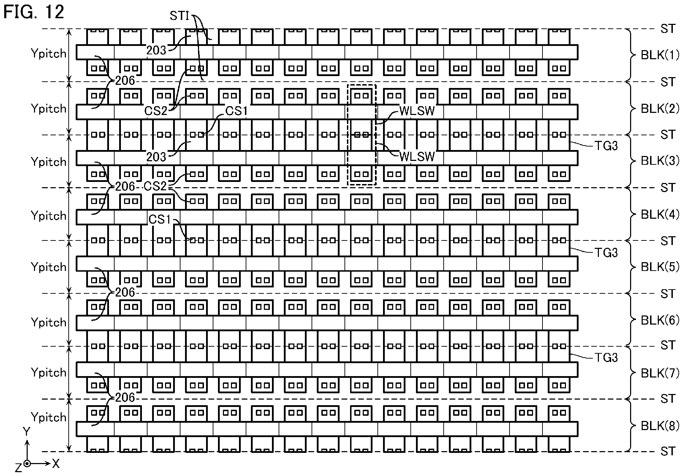

FIG. 12 is a schematic plan view showing a configuration example of the word line switch WLSW. Note that FIG. 12 corresponds to the portion indicated by A in FIG. 11, for example.

FIG. 12 shows two word line switches WLSW (transistors) having a common source region. Hereafter, such two word line switches WLSW (transistors) will be referred to as a "transistor group TG3".

As shown in FIG. 12, the transistor group TG3 comprises a semiconductor region (diffusion region) 203 extending in the Y-direction. The semiconductor regions 203 are arranged in both the X-direction and the Y-direction. The insulating region STI is formed in a periphery of the semiconductor region 203. Moreover, a contact electrode CS2 functioning as a drain terminal of the word line switch WLSW is provided in each of both end portions in the Y-direction of the semiconductor region 203. Moreover, a contact electrode CS1 functioning as a common source terminal of the two word line switches WLSW is provided between these contact electrodes CS2. Moreover, a gate insulating film 205 and a gate electrode 206 are provided between each of the contact electrodes CS2 functioning as the drain terminals and the contact electrode CS1 functioning as the source terminal.

As shown in FIG. 12, a position of an intermediate line equidistant from an end portion on a negative side in the Y-direction of one semiconductor regions 203, of a pair of the semiconductor regions 203 arranged in the Y-direction and an end portion on a positive side in the Y-direction of the other semiconductor regions 203, of the pair of semiconductor regions 203 arranged in the Y-direction coincides with a position of the inter-block insulating layer ST (FIGS. 7 and 9), viewed in the Z-direction. Moreover, a position of a center line in the Y-direction of the semiconductor region 203 coincides with a position of the inter-block insulating layer ST (FIGS. 7 and 9), viewed in the Z-direction. Spacing of the inter-block insulating layers ST arranged in the Y-direction is a pitch in the Y-direction of the word line switches WLSW (Ypitch in FIG. 12). That is, in the present embodiment, the pitch in the Y-direction of the word line switches WLSW is the same as a pitch in the Y-direction of the memory blocks BLK. The pitches in the Y-direction of the word line switches WLSW and the memory blocks BLK being the same will sometimes be notated as 1Tr/1BLK.

Note that although FIG. 12 shows a structure of the word line switch WLSW, a structure of the select gate line switch SGSW may also be configured similarly to the structure of the word line switch WLSW.

### [Paths of Block Select Lines BLKSEL and Block Select Lines BLKSELn of Chip C_{P}]

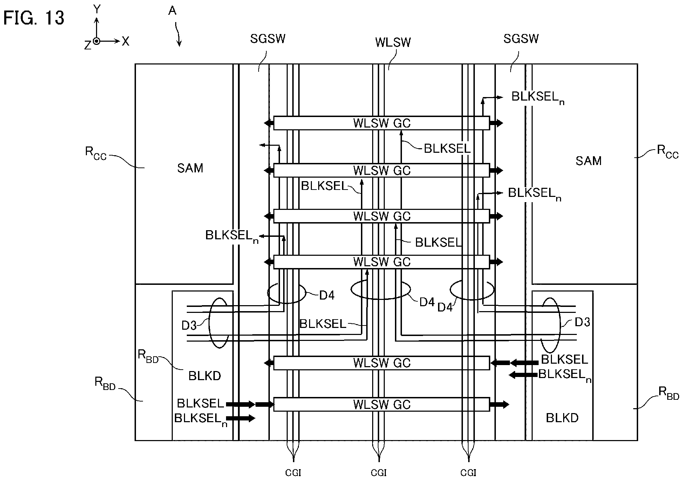

FIG. 13 is a schematic enlarged view of the portion indicated by B in FIG. 11. FIG. 13 shows how the block select lines BLKSEL and the block select lines BLKSELn of the block decoder BLKD included in the block decoder region R_{BD} are electrically connected to the word line switches WLSW and the select gate line switches SGSW via the wiring layers D3, D4. Note that FIG. 13 is a diagram for schematically explaining a connection relationship of a plurality of the block decoders BLKD and the plurality of word line switches WLSW and connection relationship of the plurality of block decoders BLKD and a plurality of the select gate line switches SGSW, and does not show specific numbers, shapes, arrangements, and so on, of configurations.

As shown in FIG. 13, the center region R_{CEN}, which is provided with the plurality of word line switches WLSW and the plurality of select gate line switches SGSW, is provided with a plurality of word line switch WLSW electrode layers GC (WLSW GC). The block decoder BLKD included in the block decoder region R_{BD} and the plurality of word line switch WLSW electrode layers GC (WLSW GC) are electrically connected by the block select lines BLKSEL passing through the wiring layers D3, D4. The block decoder BLKD included in the block decoder region R_{BD} and the select gate line switch SGSW are electrically connected by the block select lines BLKSEL, BLKSELn passing through the wiring layers D3, D4. In the wiring layer D4, the block select line BLKSEL and the block select line BLKSELn extend in the Y-direction.

### [Wiring Pattern of Block Select Lines BLKSEL in Wiring Layer D4]

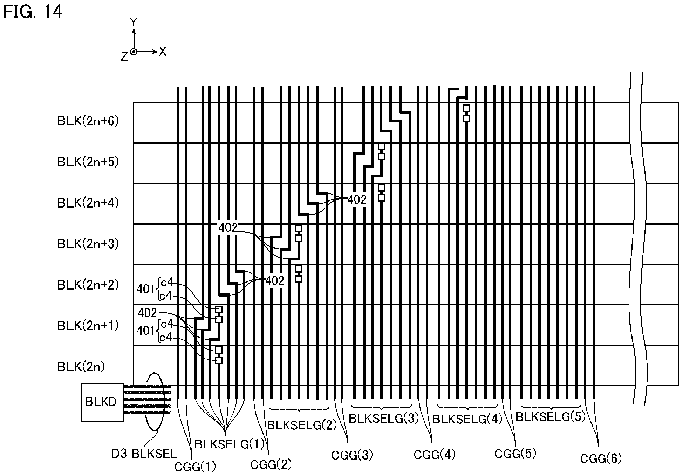

FIG. 14 is a view showing one example of a wiring pattern of the block select lines BLKSEL in the wiring layer D4. In FIG. 14, first through seventh memory blocks BLK counting from a negative side in the Y-direction are assumed to be memory blocks BLK(2n)-BLK(2n+6). First through sixth bunches of pluralities of voltage supply lines CGI (each bunch configured by two voltage supply lines CGI in FIG. 14) counting from a negative side in the X-direction are assumed to be voltage supply line groups CGG(1)-CGG(6). Moreover, first through fifth bunches of pluralities of block select lines BLKSEL (each bunch configured by seven block select lines BLKSEL in FIG. 14) counting from a negative side in the X-direction are assumed to be block select line groups BLKSELG(1)-BLKSELG(5).

As shown in FIG. 14, the voltage supply line groups CGG(1)-CGG(6) are arranged separated from each other in the X-direction. Moreover, the block select line group BLKSELG(1) is provided between the voltage supply line groups CGG(1) and CGG(2). The block select line group BLKSELG(2) is provided between the voltage supply line groups CGG(2) and CGG(3), the block select line group BLKSELG(3) is provided between the voltage supply line groups CGG(3) and CGG(4), the block select line group BLKSELG(4) is provided between the voltage supply line groups CGG(4) and CGG(5), and the block select line group BLKSELG(5) is provided between the voltage supply line groups CGG(5) and CGG(6) .

As shown in FIG. 14, in the block select line group BLKSELG(1), the fourth block select line BLKSEL from a negative side in the X-direction is connected to a connecting portion 401 at a position in the Y-direction corresponding to the memory block BLK(2n), and extends no further to a positive side in the Y-direction than this connecting portion 401. The connecting portion 401 electrically connects the block select line BLKSEL of the wiring layer D4 to the gate electrode of the word line switch WLSW via the wiring d3 in the wiring layer D3. The connecting portion 401 is configured by two contacts c4, but may be a single contact c4.

Moreover, in the block select line group BLKSELG(1), the first through third block select lines BLKSEL from a negative side in the X-direction each comprise a bent portion 402 where the block select line BLKSEL is bent in a direction of getting further away from the voltage supply line group CGG(1) (... is bent to a positive side in the X-direction), at a position in the Y-direction corresponding to the memory block BLK(2n+1). The first block select line BLKSEL from a negative side in the X-direction is configured so that its bent portion 402 will cause it to be located in (... will cause it to change its wiring path to) a direction that the second block select line BLKSEL extends on a negative side in the Y-direction of its bent portion 402. The second block select line BLKSEL from a negative side in the X-direction is configured so that its bent portion 402 will cause it to be located in (... will cause it to change its wiring path to) a direction that the third block select line BLKSEL extends on a negative side in the Y-direction of its bent portion 402. The third block select line BLKSEL from a negative side in the X-direction is configured so that its bent portion 402 will cause it to be located in (... will cause it to change its wiring path to) a direction that the fourth block select line BLKSEL extends on a negative side in the Y-direction of its connecting portion 401.

Moreover, in the block select line group BLKSELG(1), the third block select line BLKSEL from a negative side in the X-direction is connected to a connecting portion 401 at a position in the Y-direction corresponding to the memory block BLK(2n+1), and extends no further to a positive side in the Y-direction than this connecting portion 401.

Moreover, in the block select line group BLKSELG(1), the fifth through seventh block select lines BLKSEL from a negative side in the X-direction each comprise a bent portion 402 where the block select line BLKSEL is bent in a direction of getting further away from the voltage supply line group CGG(2) (... is bent to a negative side in the X-direction), at a position in the Y-direction corresponding to the memory block BLK(2n+2). The fifth block select line BLKSEL from a negative side in the X-direction is configured so that its bent portion 402 will cause it to be located in a direction that the fourth block select line BLKSEL extends on a negative side in the Y-direction of its connecting portion 401. The sixth block select line BLKSEL from a negative side in the X-direction is configured so that its bent portion 402 will cause it to be located in a direction that the fifth block select line BLKSEL extends on a negative side in the Y-direction of its bent portion 402. The seventh block select line BLKSEL from a negative side in the X-direction is configured so that its bent portion 402 will cause it to be located in a direction that the sixth block select line BLKSEL extends on a negative side in the Y-direction of its bent portion 402.

In the block select line group BLKSELG(2), similarly to in the block select line group BLKSELG(1), the fourth block select line BLKSEL from a negative side in the X-direction is connected to a connecting portion 401 at a position in the Y-direction corresponding to the memory block BLK(2n+2), and extends no further to a positive side in the Y-direction than this connecting portion 401.

Moreover, in the block select line group BLKSELG(2), the first through third block select lines BLKSEL from a negative side in the X-direction each comprise a bent portion 402 where the block select line BLKSEL is bent in a direction of getting further away from the voltage supply line group CGG(2) (... is bent to a positive side in the X-direction), at a position in the Y-direction corresponding to the memory block BLK(2n+3). The first block select line BLKSEL from a negative side in the X-direction is configured so that its bent portion 402 will cause it to be located in a direction that the second block select line BLKSEL extends on a negative side in the Y-direction of its bent portion 402. The second block select line BLKSEL from a negative side in the X-direction is configured so that its bent portion 402 will cause it to be located in a direction that the third block select line BLKSEL extends on a negative side in the Y-direction of its bent portion 402. The third block select line BLKSEL from a negative side in the X-direction is configured so that its bent portion 402 will cause it to be located in a direction that the fourth block select line BLKSEL extends on a negative side in the Y-direction of its connecting portion 401.

Moreover, in the block select line group BLKSELG(2), the third block select line BLKSEL from a negative side in the X-direction is connected to a connecting portion 401 at a position in the Y-direction corresponding to the memory block BLK(2n+3), and extends no further to a positive side in the Y-direction than this connecting portion 401.

Moreover, in the block select line group BLKSELG(2), the fifth through seventh block select lines BLKSEL from a negative side in the X-direction each comprise a bent portion 402 where the block select line BLKSEL is bent in a direction of getting further away from the voltage supply line group CGG(3) (... is bent to a negative side in the X-direction), at a position in the Y-direction corresponding to the memory block BLK(2n+4). The fifth block select line BLKSEL from a negative side in the X-direction is configured so that its bent portion 402 will cause it to be located in a direction that the fourth block select line BLKSEL extends on a negative side in the Y-direction of its connecting portion 401. The sixth block select line BLKSEL from a negative side in the X-direction is configured so that its bent portion 402 will cause it to be located in a direction that the fifth block select line BLKSEL extends on a negative side in the Y-direction of its bent portion 402. The seventh block select line BLKSEL from a negative side in the X-direction is configured so that its bent portion 402 will cause it to be located in a direction that the sixth block select line BLKSEL extends on a negative side in the Y-direction of its bent portion 402.

In the block select line group BLKSELG(3), similarly to in the block select line groups BLKSELG(1), BLKSELG(2), the fourth block select line BLKSEL from a negative side in the X-direction is connected to a connecting portion 401 at a position in the Y-direction corresponding to the memory block BLK(2n+4), and extends no further to a positive side in the Y-direction than this connecting portion 401.

Moreover, in the block select line group BLKSELG(3), the first through third block select lines BLKSEL from a negative side in the X-direction each comprise a bent portion 402 where the block select line BLKSEL is bent in a direction of getting further away from the voltage supply line group CGG(3) (... is bent to a positive side in the X-direction), at a position in the Y-direction corresponding to the memory block BLK(2n+5). The first block select line BLKSEL from a negative side in the X-direction is configured so that its bent portion 402 will cause it to be located in a direction that the second block select line BLKSEL extends on a negative side in the Y-direction of its bent portion 402. The second block select line BLKSEL from a negative side in the X-direction is configured so that its bent portion 402 will cause it to be located in a direction that the third block select line BLKSEL extends on a negative side in the Y-direction of its bent portion 402. The third block select line BLKSEL from a negative side in the X-direction is configured so that its bent portion 402 will cause it to be located in a direction that the fourth block select line BLKSEL extends on a negative side in the Y-direction of its connecting portion 401.

Moreover, in the block select line group BLKSELG(3), the third block select line BLKSEL from a negative side in the X-direction is connected to a connecting portion 401 at a position in the Y-direction corresponding to the memory block BLK(2n+5), and extends no further to a positive side in the Y-direction than this connecting portion 401.

Moreover, in the block select line group BLKSELG(3), the fifth through seventh block select lines BLKSEL from a negative side in the X-direction each comprise a bent portion 402 where the block select line BLKSEL is bent in a direction of getting further away from the voltage supply line group CGG(4) (... is bent to a negative side in the X-direction), at a position in the Y-direction corresponding to the memory block BLK(2n+6). The fifth block select line BLKSEL from a negative side in the X-direction is configured so that its bent portion 402 will cause it to be located in a direction that the fourth block select line BLKSEL extends on a negative side in the Y-direction of its connecting portion 401. The sixth block select line BLKSEL from a negative side in the X-direction is configured so that its bent portion 402 will cause it to be located in a direction that the fifth block select line BLKSEL extends on a negative side in the Y-direction of its bent portion 402. The seventh block select line BLKSEL from a negative side in the X-direction is configured so that its bent portion 402 will cause it to be located in a direction that the sixth block select line BLKSEL extends on a negative side in the Y-direction of its bent portion 402.

Note that descriptions for the block select line groups BLKSELG(4)-BLKSELG(5) will be omitted due to them being similar to those for the block select line groups BLKSELG(1)-BLKSELG(3). Moreover, descriptions for the block select line groups BLKSELnG(1)-BLKSELnG(5) will also be omitted due to them being similar to those for the block select line groups BLKSELG(1)-BLKSELG(3).

Note that the number of block select lines BLKSEL configuring the block select line groups BLKSELG(1)-BLKSELG(5) is not limited to seven. Moreover, the number of voltage supply lines CGI configuring the voltage supply line groups CGG(1)-CGG(6) is not limited to two either, and may be four, for example.

Moreover, positions where the connecting portions 401 and the bent portions 402 are provided in the block select line groups BLKSELG(1)-BLKSELG(5) are not limited to the above-mentioned positions in the Y-direction corresponding to the memory blocks BLK. Any position may be acceptable, provided there is a decrease in total value of length of the block select lines BLKSEL closely adjacent to the voltage supply line groups CGG(1)-CGG(6).

### [Connecting Configuration of Wiring Layer D4 and Wiring Layer D3 of Block Select Lines BLKSEL]

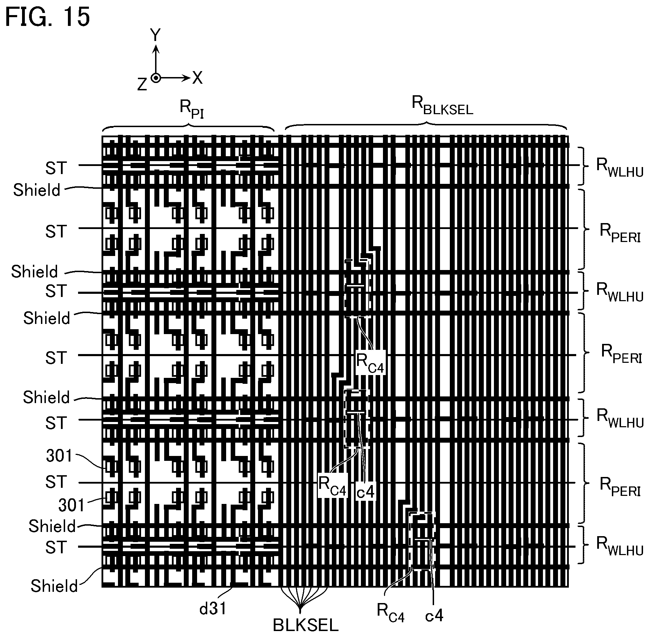

FIG. 15 is a view showing one example of a wiring pattern of the block select lines BLKSEL in the wiring layer D3.

FIG. 15 shows: a BLKSEL region R_{BLKSEL} provided with a plurality of the block select lines BLKSEL in the wiring layer D3; and a bonding pad region R_{PI} provided with a plurality of bonding pad electrodes 301 and a wiring d31. In addition, FIG. 15 shows: a hook-up wiring region R_{WLHU} provided with a plurality of hook-up wirings; a passing wiring region R_{PERI} provided with a plurality of passing wirings; the inter-block insulating layer ST indicating a boundary of the memory blocks BLK; and a shield wiring Shield.

The shield wiring Shield is a wiring for shielding the hook-up wirings provided in the hook-up wiring region R_{WLHU} and the passing wirings provided in the passing wiring region R_{PERI}. During the read operation, the write operation, an erase operation, and so on, the hook-up wirings are applied with a high voltage such as a read pass voltage or write voltage, an erase voltage, and so on, whereas many wirings of the passing wirings are applied with a comparatively low voltage from the ground voltage V_{SS} to about the power supply voltage V_{CC}. It is easy for voltage of a wiring adjacent to a wiring applied with a high voltage to rise unintentionally due to capacitive coupling. In order to suppress voltage fluctuation of the passing wirings, the shield wiring Shield is provided between the hook-up wiring region R_{WLHU} and the passing wiring region R_{PERI}, and shields the hook-up wirings and the passing wirings.

The block select line BLKSEL of the wiring layer D3 and the block select line BLKSEL of the wiring layer D4 are connected via the contact c4 of a connecting region R_{C4} in the BLKSEL region R_{BLKSEL}. As shown in FIG. 15, the contact c4 of the connecting region R_{C4} is provided in the hook-up wiring region R_{WLHU} of the BLKSEL region R_{BLKSEL}. In other words, the contact c4 of the connecting region R_{C4} is provided in the hook-up wiring region R_{WLHU} avoiding the passing wiring region R_{PERI} provided with the power supply, and so on, in the BLKSEL region R_{BLKSEL} not provided with the bonding pad electrode 301.

### [Advantages]

As described with reference to FIGS. 11, 13, and so on, the plurality of block decoders BLKD are not disposed (extending in the Y-direction) along the center region R_{CEN} (the word line switches WLSW and the select gate line switches SGSW) on both sides in the X-direction of the center region R_{CEN}, but are disposed separated from each other on both sides in the X-direction of the center region R_{CEN} of the peripheral circuit region R_{PC}. It therefore becomes possible for position in the Y-direction of the block decoder region R_{BD} to be made different from that of the column control circuit region R_{CC}, and for chip size to be thereby shortened in the X-direction. However, this results in the block select line BLKSEL and the block select line BLKSELn passing between the voltage supply lines CGI, and results in the voltage supply line CGI and the block select line BLKSEL or the voltage supply line CGI and the block select line BLKSELn being adjacent. The voltage supply line CGI and the block select line BLKSEL are each applied with a high voltage, so when distance (space) between the voltage supply line CGI and the block select line BLKSEL or voltage supply line CGI and the block select line BLKSELn is small, or the voltage supply line CGI and the block select line BLKSEL or voltage supply line CGI and the block select line BLKSELn face each over a long distance, then sometimes, yield of the chip C_{P} will worsen due to effects such as a TDDB (Time Dependent Dielectric Breakdown) malfunction caused by a high voltage difference or a wiring short-circuit caused by dust during manufacturing. Moreover, sometimes, due to the voltage supply line CGI being applied with a high voltage, the block select line BLKSEL and the block select line BLKSELn will receive noise, and the chip C_{P} operates unfavorably.

On the other hand, when the block select line BLKSEL and the block select line BLKSELn protrude from the region provided with the word line switches WLSW and the select gate line switches SGSW viewed in the Z-direction, then size of the chip C_{P} will increase. It is therefore sometimes difficult to provide a single block select line BLKSEL portion of space in a place adjacent to the voltage supply line CGI.

Accordingly, in the present embodiment, as described with reference to FIG. 14, a part of the plurality of block select lines BLKSEL passing between the voltage supply line groups CGG arranged separated from each other in the X-direction in the wiring layer D4 is connected to the wiring layer D3 and the space thereby opened utilized to change the wiring paths of the remaining block select lines BLKSEL so that they get further away from the voltage supply lines CGI of the voltage supply line groups CGG. Hence, regardless of it being possible for many block select lines BLKSEL to be provided between the voltage supply line groups CGG, at least a single block select line BLKSEL portion of space between the block select line BLKSEL and the voltage supply line CGI adjacent in the voltage supply line groups CGG, can be secured, and furthermore, a total of lengths of the block select lines BLKSEL adjacent to the voltage supply lines CGI can by shortened. As a result, the possibility of the voltage supply line CGI and the block select line BLKSEL being short-circuited due to effects such as dust during manufacturing, can be suppressed, so lowering of yield of the chip C_{P} can be suppressed. Moreover, due to it being possible for a space between the block select line BLKSEL and the voltage supply line CGI adjacent in the voltage supply line groups CGG to be secured, the effect of noise received by the block select line BLKSEL and the block select line BLKSELn can be suppressed, and unfavorable operation of the chip C_{P} thereby suppressed, even when the voltage supply line CGI is applied with a high voltage.

### [Second Embodiment]

### [Wiring Pattern of Block Select Lines BLKSEL, and so on, in Wiring Layer D4]

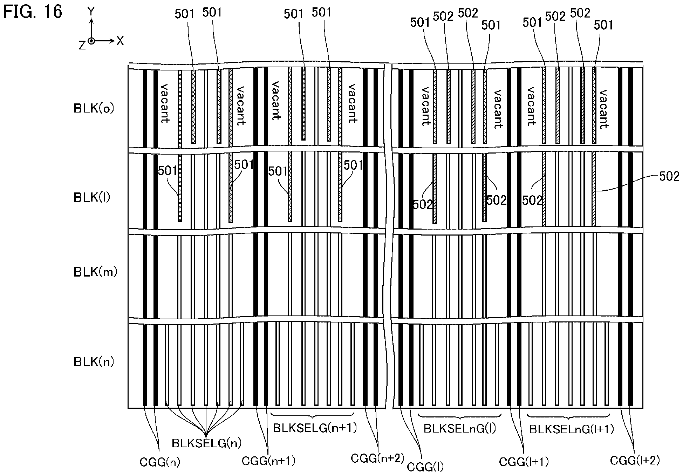

FIG. 16 is a view showing one example of a wiring pattern of block select lines BLKSEL, and so on, in a wiring layer D4 according to a second embodiment. Note that FIG. 16 is a diagram for explaining a schematic wiring pattern of the block select lines BLKSEL, voltage supply lines CGI, ground voltage V_{SS}, and power supply voltage V_{CC} in the wiring layer D4 according to the second embodiment, and does not show specific numbers, shapes, arrangements, and so on, of configurations.

The first through fourth memory blocks BLK counting from a negative side in the Y-direction, of the plurality of memory blocks BLK illustrated in FIG. 16 are assumed to be memory blocks BLK(n)-BLK(o). First through third bunches of pluralities of voltage supply lines CGI (each bunch configured by two voltage supply lines CGI in FIG. 16) counting from a negative side in the X-direction are assumed to be voltage supply line groups CGG(n)-CGG(n+2), and fourth through sixth bunches of pluralities of voltage supply lines CGI (each bunch configured by two voltage supply lines CGI in FIG. 16) counting from a negative side in the X-direction are assumed to be voltage supply line groups CGG(l)-CGG(l+2). Moreover, first and second bunches of pluralities of block select lines BLKSEL, BLKSELn (each bunch configured by seven block select lines BLKSEL in FIG. 16) counting from a negative side in the X-direction are assumed to be block select line groups BLKSELG(n), BLKSELG(n+1), and third and fourth bunches of pluralities of block select lines BLKSEL, BLKSELn (each bunch configured by seven block select lines BLKSELn in FIG. 16) counting from a negative side in the X-direction are assumed to be block select line groups BLKSELnG(l), BLKSELnG(l+1).

As shown in FIG. 16, the voltage supply line groups CGG(n)-CGG(n+2), CGG(l)-CGG(l+2) are arranged separated from each other in the X-direction. The block select line group BLKSELG(n) is provided between the voltage supply line group CGG(n) and the voltage supply line group CGG(n+1). The plurality of block select lines BLKSEL of the block select line group BLKSELG(n) have their wiring paths changed to directions that they get further away from the voltage supply line group CGG(n) and the voltage supply line group CGG(n+1) (... to positive and negative sides in the X-direction), by unillustrated bent portions or connecting portions. As a result, in the block select line group BLKSELG(n), a single block select line BLKSEL wiring width portion of space will be opened from each of the voltage supply line groups CGG(n) and CGG(n+1) at a position in the Y-direction corresponding to the memory block BLK(m), a two block select line BLKSEL wiring width portion of space will be opened from each of the voltage supply line groups CGG(n) and CGG(n+1) at a position in the Y-direction corresponding to the memory block BLK(l), and a three block select line BLKSEL wiring width portion of space will be opened from each of the voltage supply line groups CGG(n) and CGG(n+1) at a position in the Y-direction corresponding to the memory block BLK(o).

Moreover, in the block select line group BLKSELG(n), spaces adjacent to the third through fifth block select lines BLKSEL (spaces in extending directions of the second and sixth block select lines BLKSEL), of the two block select line BLKSEL wiring width portions of space opened at a position in the Y-direction corresponding to the memory block BLK(l), are each provided with a power supply line 501 of the ground voltage V_{SS}, for example. As a result, noise between the voltage supply line group CGG(n) and the block select line group BLKSELG(n), and between the voltage supply line group CGG(n+1) and the block select line group BLKSELG(n), can be blocked. Moreover, in the block select line group BLKSELG(n), two wiring portion spaces adjacent to the fourth block select line BLKSEL (spaces in extending directions of the second, third, fifth, and sixth block select lines BLKSEL), of the three block select line BLKSEL wiring width portions of space opened at a position in the Y-direction corresponding to the memory block BLK(o), are each provided with the power supply line 501 of the ground voltage V_{SS}, for example. As a result, noise between the voltage supply line group CGG(n) and the block select line group BLKSELG(n), and between the voltage supply line group CGG(n+1) and the block select line group BLKSELG(n), can be blocked.

The block select line group BLKSELG(n+1) is provided between the voltage supply line group CGG(n+1) and the voltage supply line group CGG(n+2). The plurality of block select lines BLKSEL of the block select line group BLKSELG(n+1) have their wiring paths changed to directions that they get further away from the voltage supply line group CGG(n+1) and the voltage supply line group CGG(n+2) (... to positive and negative sides in the X-direction), by unillustrated bent portions or connecting portions. As a result, in the block select line group BLKSELG(n+1), a single block select line BLKSEL wiring width portion of space will be opened from each of the voltage supply line groups CGG(n+1) and CGG(n+2) at a position in the Y-direction corresponding to the memory block BLK(m), a two block select line BLKSEL wiring width portion of space will be opened from each of the voltage supply line groups CGG(n+1) and CGG(n+2) at a position in the Y-direction corresponding to the memory block BLK(l), and a three block select line BLKSEL wiring width portion of space will be opened from each of the voltage supply line groups CGG(n+1) and CGG(n+2) at a position in the Y-direction corresponding to the memory block BLK(o).

Moreover, in the block select line group BLKSELG(n+1), spaces adjacent to the third through fifth block select lines BLKSEL, of the two block select line BLKSEL wiring width portions of space opened at a position in the Y-direction corresponding to the memory block BLK(l), are each provided with the power supply line 501 of the ground voltage V_{SS}, for example. As a result, noise between the voltage supply line group CGG(n+1) and the block select line group BLKSELG(n+1), and between the voltage supply line group CGG(n+2) and the block select line group BLKSELG(n+1), can be blocked. Moreover, in the block select line group BLKSELG(n+1), two wiring portion spaces adjacent to the fourth block select line BLKSEL, of the three block select line BLKSEL wiring width portions of space opened at a position in the Y-direction corresponding to the memory block BLK(o), are each provided with the power supply line 501 the ground voltage V_{SS}, for example. As a result, noise between the voltage supply line group CGG(n+1) and the block select line group BLKSELG(n+1), and between the voltage supply line group CGG(n+2) and the block select line group BLKSELG(n+1), can be blocked.

The block select line group BLKSELnG(l) is provided between the voltage supply line group CGG(l) and the voltage supply line group CGG(l+1). The plurality of block select lines BLKSELn of the block select line group BLKSELnG(l) have their wiring paths changed to directions that they get further away from the voltage supply line group CGG(l) and the voltage supply line group CGG(l+1) (... to positive and negative sides in the X-direction), by unillustrated bent portions or connecting portions. As a result, in the block select line group BLKSELnG(l), a single block select line BLKSELn wiring width portion of space will be opened from each of the voltage supply line groups CGG(l) and CGG(l+1) at a position in the Y-direction corresponding to the memory block BLK(m), a two block select line BLKSELn wiring width portion of space will be opened from each of the voltage supply line groups CGG(l) and CGG(l+1) at a position in the Y-direction corresponding to the memory block BLK(l), and a three block select line BLKSELn wiring width portion of space will be opened from each of the voltage supply line groups CGG(l) and CGG(l+1) at a position in the Y-direction corresponding to the memory block BLK(o).

Moreover, in the block select line group BLKSELnG(l), spaces adjacent to the third through fifth block select lines BLKSELn (spaces in extending directions of the second and sixth block select lines BLKSELn), of the two block select line BLKSELn wiring width portions of space opened at a position in the Y-direction corresponding to the memory block BLK(l), are each provided with a power supply line 502 of a voltage Vdd, for example. The voltage Vdd is a power supply voltage utilized by the block decoder BLKD.

As a result, noise between the voltage supply line group CGG(l) and the block select line group BLKSELnG(l), and between the voltage supply line group CGG(l+1) and the block select line group BLKSELnG(l), can be blocked. Moreover, in the block select line group BLKSELnG(l), single wiring portion spaces adjacent to the fourth block select line BLKSELn (spaces in extending directions of the third and fifth block select lines BLKSELn), of the three block select line BLKSELn wiring width portions of space opened at a position in the Y-direction corresponding to the memory block BLK(o), are each provided with the power supply line 502 of the voltage Vdd, for example, and single wiring portion spaces adjacent to the power supply lines 502 (spaces in extending directions of the second and sixth block select lines BLKSELn), of the three block select line BLKSELn wiring width portions of space opened at a position in the Y-direction corresponding to the memory block BLK(o), are each provided with the power supply line 501 the ground voltage V_{SS}, for example. As a result, noise between the voltage supply line group CGG(l) and the block select line group BLKSELnG(l), and between the voltage supply line group CGG(l+1) and the block select line group BLKSELnG(l), can be blocked.

Moreover, in the case of a short-circuit malfunction having occurred between the power supply line 502 and the block select line group BLKSELnG(l), it will lead to a state where, in the memory block BLK(l), the drain side select gate lines SGD and the source side select gate lines SGS are constantly applied with the ground voltage V_{SS}. As a result, said memory block BLK(l) will constantly have its drain side select transistors STD and the source side select transistors STS set to OFF. In this case, even when it has become impossible to operate said memory block BLK(l), the possibility of a memory cell MC in said memory block BLK(l) being electrically connected to a memory cell MC in another memory block BLK can be suppressed, for example. That is, even when a short-circuit malfunction occurs between the power supply line 502 and the block select line group BLKSELnG(l), it can be kept to a malfunction in a certain single memory block BLK, such as the memory block BLK(l) only, or memory block BLK(o) only.

The block select line group BLKSELnG(l+1) is provided between the voltage supply line group CGG(l+1) and the voltage supply line group CGG(l+2). The plurality of block select lines BLKSELn of the block select line group BLKSELnG(l+1) have their wiring paths changed to directions that they get further away from the voltage supply line group CGG(l+1) and the voltage supply line group CGG(l+2) (... to positive and negative sides in the X-direction), by unillustrated bent portions or connecting portions. As a result, in the block select line group BLKSELnG(l+1), a single block select line BLKSELn wiring width portion of space will be opened from each of the voltage supply line group CGG(l+1) and the voltage supply line group CGG(l+2) at a position in the Y-direction corresponding to the memory block BLK(m), a two block select line BLKSELn wiring width portion of space will be opened from each of the voltage supply line groups CGG(l+1) and the voltage supply line group CGG(l+2) at a position in the Y-direction corresponding to the memory block BLK(l), and a three block select line BLKSELn wiring width portion of space will be opened from each of the voltage supply line groups CGG(l+1) and the voltage supply line group CGG(l+2) at a position in the Y-direction corresponding to the memory block BLK(o).

Moreover, in the block select line group BLKSELnG(l+1), spaces adjacent to the third through fifth block select lines BLKSELn (spaces in extending directions of the second and sixth block select lines BLKSELn), of the two block select line BLKSELn wiring width portions of space opened at a position in the Y-direction corresponding to the memory block BLK(l), are each provided with the power supply line 502 of the voltage Vdd, for example. As a result, noise between the voltage supply line group CGG(l+1) and the block select line group BLKSELnG(l+1), and between the voltage supply line group CGG(l+2) and the block select line group BLKSELnG(l+1), can be blocked. Moreover, in the block select line group BLKSELnG(l+1), single wiring portion spaces adjacent to the fourth block select line BLKSELn (spaces in extending directions of the third and fifth block select lines BLKSELn), of the three block select line BLKSELn wiring width portions of space opened at a position in the Y-direction corresponding to the memory block BLK(o), are each provided with the power supply line 502 of the voltage Vdd, for example, and single wiring portion spaces adjacent to the power supply lines 502 (spaces in extending directions of the second and sixth block select lines BLKSELn), of the three block select line BLKSELn wiring width portions of space opened at a position in the Y-direction corresponding to the memory block BLK(o), are each provided with the power supply line 501 of the ground voltage V_{SS}, for example. As a result, noise between the voltage supply line group CGG(l+1) and the block select line group BLKSELnG(l+1), and between the voltage supply line group CGG(l+2) and the block select line group BLKSELnG(l+1), can be blocked. Moreover, even when a short-circuit malfunction occurs between the power supply line 502 and the block select line group BLKSELnG(l+1), it can be kept to a malfunction in a single memory block BLK, such as the memory block BLK(l) only, or memory block BLK(o) only.

Due to this kind of configuration, the wiring pattern of the second embodiment, too, similarly to the wiring pattern of the first embodiment, results in the block select lines BLKSEL or the block select lines BLKSELn closely adjacent to the voltage supply lines CGI having their wiring paths changed so that they get further away from the voltage supply lines CGI, and results in single wiring portions of space being secured in vicinities of the voltage supply lines CGI. Furthermore, in the second embodiment, when at least a two wiring portion of space can be provided adjacently to the voltage supply line CGI, then the wiring portion of space non-adjacent to the voltage supply line CGI can be provided with a power supply line, so that noise between the voltage supply line CGI and the block select line BLKSEL or the block select line BLKSELn can be reduced.

Note that in the configuration of FIG. 16, the power supply line 501 may be applied with a negative voltage V_{BB}, rather than the ground voltage V_{SS}. In this case, when a short-circuit malfunction has occurred between the power supply line 501 and the block select line group BLKSELG(n), for example, then it will lead to a state where, in the memory block BLK(l), the drain side select gate lines SGD and the source side select gate lines SGS are constantly cut off from the voltage supply lines CGI. As a result, it can be avoided that said memory block BLK(l) has its drain side select transistors STD and the source side select transistors STS unintentionally set to ON. In this case, even when it has become impossible to operate said memory block BLK(l), the possibility of a memory cell MC in said memory block BLK(l) being electrically connected to a memory cell MC in another memory block BLK can be suppressed, for example. That is, even when a short-circuit malfunction occurs between the power supply line 501 and the block select line group BLKSELG(n), it can be kept to a malfunction in a certain single memory block BLK, such as the memory block BLK(l) only, or memory block BLK(o) only.

### [Third Embodiment]

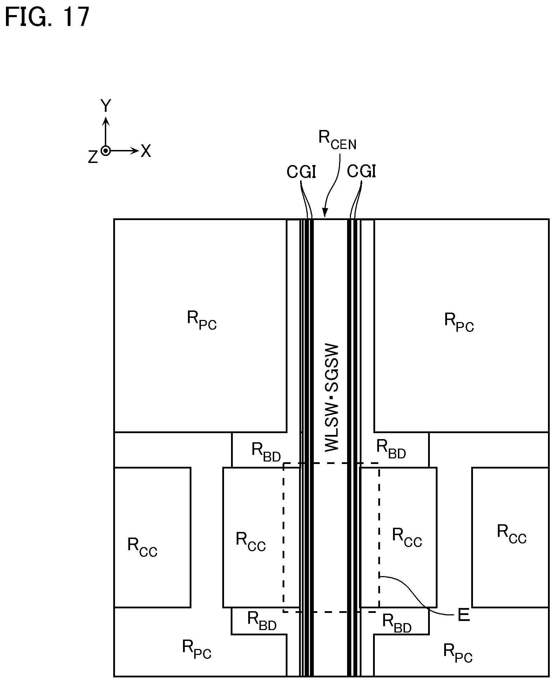

FIG. 17 is a schematic plan view showing a configuration example of part of a chip C_{P} according to a third embodiment. Note that FIG. 17 corresponds to one portion of, for example, plane FP1' of the four planes FP0'-FP3' shown in FIG. 11, for example. In FIG. 17, configurations the same as in FIG. 11, and so on, are assigned with the same symbols as in FIG. 11, and so on, and duplicated descriptions thereof omitted.

In the configuration of the first embodiment, three of the block decoder regions R_{BD} provided with the block decoder BLKD were provided separated from each other in the Y-direction on both sides in the X-direction of the center region R_{CEN} (FIG. 11). In contrast, in the configuration of the third embodiment, the block decoder regions R_{BD} are provided separately from each other on both sides in the X-direction of the center region R_{CEN} and on parts of both sides in the Y-direction of the column control circuit region R_{CC}. Furthermore, in the configuration of the third embodiment, the block decoder regions R_{BD} are provided extending in the Y-direction so as to lie along both sides in the X-direction of the center region R_{CEN} on positive and negative sides in the Y-direction of the column control circuit region R_{CC}.

Thus, even in the configuration of the third embodiment where arrangement of the block decoder regions R_{BD} differs from in the first embodiment, the wiring pattern where wiring paths of the block select lines BLKSEL or the block select lines BLKSELn closely adjacent to the voltage supply lines CGI are changed so that they get further away from the voltage supply lines CGI, and single wiring portions of space are secured in vicinities of the voltage supply lines CGI, can be adopted in the portion at E (the region including the center region R_{CEN}) of FIG. 17.

Note that there is no need for the wiring pattern described in the first embodiment to be adopted in a region including the center region R_{CEN} other than the portion at E in FIG. 17. However, even in such a case, it is preferable for a single wiring portion of space to be secured in a vicinity of the voltage supply line CGI.

Note that a configuration having a different arrangement of the block decoder regions R_{BD} from in the first embodiment, that allows adoption of the wiring pattern described in the first embodiment, is not limited to the configuration described in the third embodiment.

### [Fourth Embodiment]

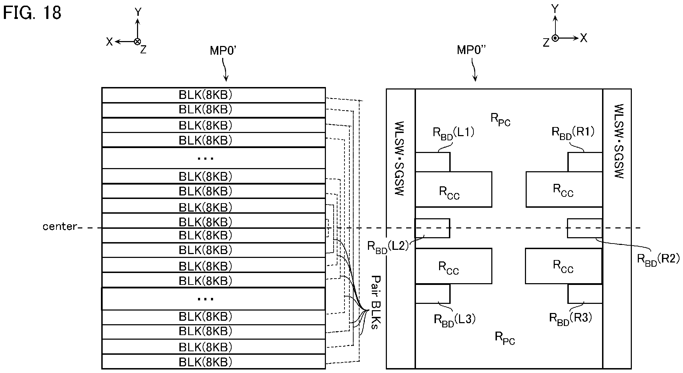

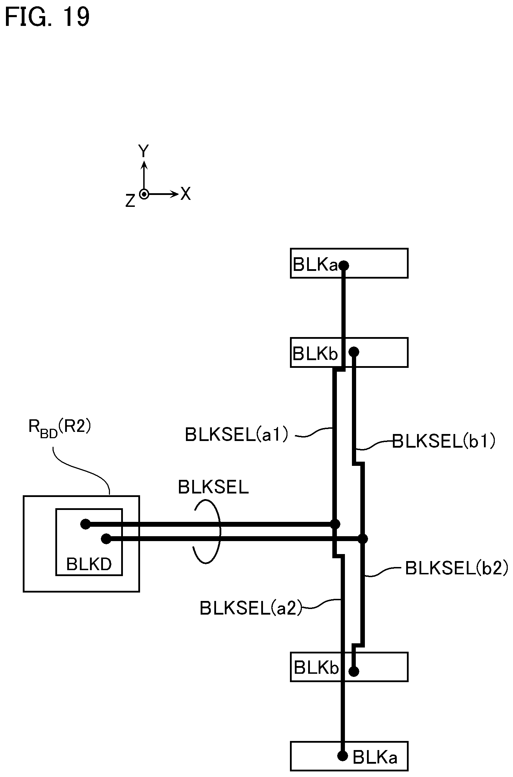

FIG. 18 is a view for explaining a configuration example of parts of a chip C_{M} and a chip C_{P} according to a fourth embodiment. In the example of FIG. 18, a memory plane MP0' shown as part of chip C_{M} corresponds to memory plane MP0 of FIG. 6, for example. In the example of FIG. 18, a plane MP0'' shown as part of chip C_{P} corresponds to a region overlapping memory plane MP0 of FIG. 6, for example. FIG. 19 is a view showing one example of a wiring pattern of block select lines BLKSEL in a wiring layer D4 according to the fourth embodiment. In FIGS. 18 and 19, configurations the same as in FIGS. 11, 14, and so on, are assigned with the same symbols as in FIGS. 11, 14, and so on, and duplicated descriptions thereof omitted.

In the memory plane MP0', as shown in FIG. 18, the case is shown where a physical plane (memory block BLK) is upwardly/downwardly divided into logical planes of 8KB each, and logically operated in 16KB pair blocks. In the pair block, one memory block BLK on a positive side in the Y-direction of center (the upper side in FIG. 18) and one memory block BLK on a negative side in the Y-direction of center (the lower side in FIG. 18) (referred to as upper and lower memory blocks BLK), are simultaneously selected.

In the plane MP0'', as shown in FIG. 18, the block decoder regions R_{BD} are provided separately from each other on one side in the X-direction of a region provided with the word line switches WLSW and the select gate line switches SGSW and on parts of both sides in the Y-direction of the column control circuit region R_{CC}.

Note that the block decoder regions R_{BD} may be provided along one side in the X-direction of the region provided with the word line switches WLSW and the select gate line switches SGSW. Moreover, in FIG. 18, the first through third block decoder regions R_{BD} on a negative side in the X-direction (the left side) counting from a positive side in the Y-direction are assumed to be block decoder regions R_{BD}(L1)-R_{BD}(L3). Similarly, in FIG. 18, the first through third block decoder regions R_{BD} on a positive side in the X-direction (the right side) counting from a positive side in the Y-direction are assumed to be block decoder regions R_{BD}(R1)-R_{BD}(R3).

The block decoders BLKD provided in these block decoder regions R_{BD} can simultaneously drive the upper and lower memory blocks BLK(8kb) of the memory plane MP0'. Specifically, the block decoder BLKD provided in the block decoder region R_{BD}(L1) and the block decoder BLKD provided in the block decoder region R_{BD}(L3) are simultaneously operated, and the block decoder BLKD provided in the block decoder region R_{BD}(R1) and the block decoder BLKD provided in the block decoder region R_{BD}(R3) are simultaneously operated to simultaneously drive the upper and lower memory blocks BLK (8kb). The block decoder BLKD provided in the block decoder region R_{BD}(L2) or the block decoder BLKD provided in the block decoder region R_{BD}(R2) simultaneously drives the upper and lower memory blocks BLK(8kb) close to center. Adopting such a configuration enables the number of block decoders BLKD provided to be reduced.

Moreover, in the case of adopting such a drive system, as shown in FIG. 19, for example, the block decoder BLKD provided in the block decoder region R_{BD}(R2) electrically connects the block select line BLKSEL, which is branched into a block select line BLKSEL(a1) on a positive side in the Y-direction and the block select line BLKSEL(a2) on a negative side in the Y-direction, to memory blocks BLKa on a positive side in the Y-direction and a negative side in the Y-direction. This enables the memory blocks BLKa on a positive side in the Y-direction and a negative side in the Y-direction to be simultaneously driven. Similarly, the block decoder BLKD provided in the block decoder region R_{BD}(R2) electrically connects the block select line BLKSEL, which is branched into a block select line BLKSEL(b1) on a positive side in the Y-direction and the block select line BLKSEL(b2) on a negative side in the Y-direction, to memory blocks BLKb on a positive side in the Y-direction and a negative side in the Y-direction. This enables the memory blocks BLKb on a positive side in the Y-direction and a negative side in the Y-direction to be simultaneously driven.

Thus, in the configuration of the fourth embodiment, even in the case where, for example, the block select line BLKSEL is branched into the likes of the block select line BLKSEL(b1) on a positive side in the Y-direction and the block select line BLKSEL(b2) on a negative side in the Y-direction, the wiring pattern of the block select lines BLKSEL in the wiring layer D4 according to the first embodiment, that is, the wiring pattern where wiring paths of the block select lines BLKSEL or the block select lines BLKSELn closely adjacent to the voltage supply lines CGI are changed so that they get further away from the voltage supply lines CGI, and single wiring portions of space are secured in vicinities of the voltage supply lines CGI, can be adopted in the branched block select line BLK.

### [Other Embodiments]

That concludes description of the semiconductor memory devices according to the first through fourth embodiments. However, the configurations described above are merely exemplifications, and specific configurations may be appropriately adjusted.

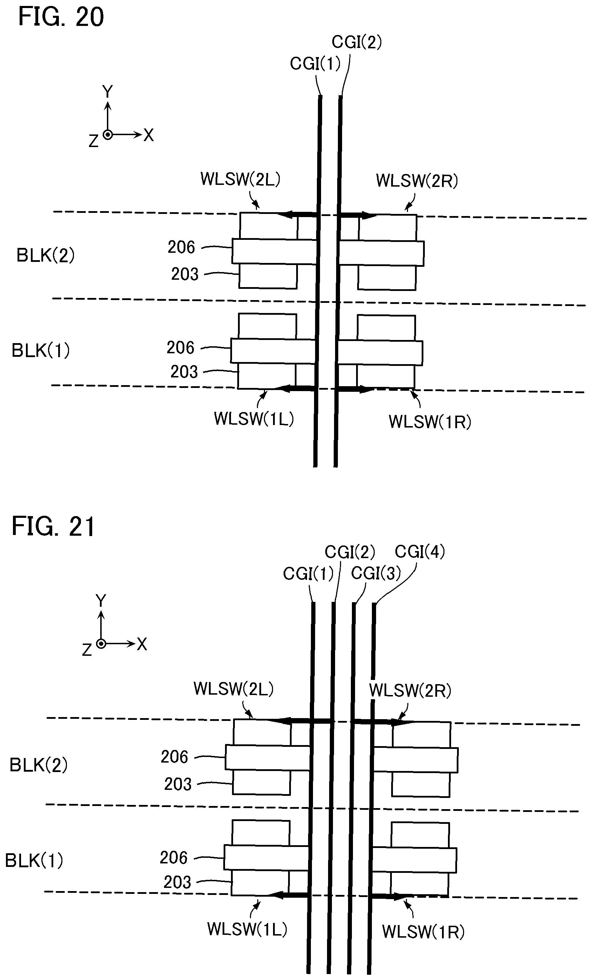

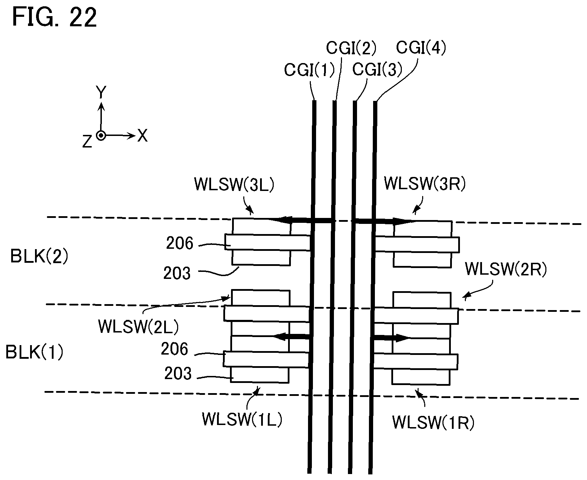

FIG. 20 is a schematic view showing a positional relationship of the word line switches WLSW and the memory blocks BLK according to the first embodiment. FIGS. 21 and 22 are schematic views showing a positional relationship of word line switches WLSW and the memory blocks BLK according to another embodiment. Note that in FIGS. 20 to 22, dotted lines indicating boundaries of the memory blocks BLK are shown to explain a correspondence relationship of the word line switches WLSW and the memory blocks BLK. In FIGS. 20 to 22, the first and second memory blocks BLK counting from a negative side in the Y-direction are assumed to be memory blocks BLK(1), BLK(2). The first and second voltage supply lines CGI counting from a negative side in the X-direction are assumed to be voltage supply lines CGI(1), CGI(2).

As shown in FIG. 20, for example, in the first embodiment, and so on, the voltage supply line group CGG is configured by two voltage supply lines CGI(1), CGI(2). FIG. 20 shows two word line switches WLSW(1L), WLSW(1R) provided at a position in the Y-direction corresponding to the memory block BLK(1). In addition, FIG. 20 shows two word line switches WLSW(2L), WLSW(2R) provided at a position in the Y-direction corresponding to the memory block BLK(2).

Moreover, source electrodes of the word line switches WLSW are each electrically connected to one voltage supply line CGI. Specifically, at a position in the Y-direction corresponding to the memory block BLK(1), the word line switch WLSW(1L) and the voltage supply line CGI(1) are electrically connected, and the word line switch WLSW(1R) and the voltage supply line CGI(2) are electrically connected. Moreover, at a position in the Y-direction corresponding to the memory block BLK(2), the word line switch WLSW(2L) and the voltage supply line CGI(1) are electrically connected, and the word line switch WLSW(2R) and the voltage supply line CGI(2) are electrically connected. When the voltage supply line group CGG is configured by two voltage supply lines CGI in this way, wiring layout is simplified. Note that when the voltage supply line group CGG is configured by a single voltage supply line CGI, then places where the block select gate lines BLKSEL and the voltage supply lines CGI are adjacent, will increase.

As shown in FIG. 21, the voltage supply line group CGG may be configured by four voltage supply lines CGI(1), CGI(2), CGI(3), CGI(4).

In this case too, source electrodes of the word line switches WLSW are each electrically connected to one voltage supply line CGI. Specifically, at a position in the Y-direction corresponding to the memory block BLK(1), the word line switch WLSW(1L) and the voltage supply line CGI(1) may be electrically connected, and the word line switch WLSW(1R) and the voltage supply line CGI(4) may be electrically connected. Moreover, at a position in the Y-direction corresponding to the memory block BLK(2), the word line switch WLSW(2L) and the voltage supply line CGI(2) may be electrically connected, and the word line switch WLSW(2R) and the voltage supply line CGI(3) may be electrically connected.

In the examples shown in FIGS. 20 and 21, the pitch in the Y-direction of the word line switches WLSW is the same as the pitch in the Y-direction of the memory blocks BLK, so there is 1Tr/1BLK. In contrast, in the example shown in FIG. 22, three times the pitch in the Y-direction of the word line switches WLSW is the same as two times the pitch in the Y-direction of the memory blocks BLK, resulting in there being 3Tr/2BLK.

As shown in FIG. 22, the voltage supply line group CGG may be configured by four voltage supply lines CGI(1), CGI(2), CGI(3), CGI(4), and be 3Tr/2BLK.

In this case, at a position in the Y-direction corresponding to the memory block BLK(1), the word line switch WLSW(1L), the word line switch WLSW(2L) and the voltage supply line CGI(1) may be electrically connected, and the word line switches WLSW(1R), the word line switch WLSW(2R) and the voltage supply line CGI(4) may be electrically connected. Moreover, at a position in the Y-direction corresponding to the memory block BLK(2), the word line switch WLSW(3L) and the voltage supply line CGI(2) may be electrically connected, and the word line switch WLSW(3R) and the voltage supply line CGI(3) may be electrically connected.

In the above embodiments, there have been described examples applied to NAND flash memory. However, technology described in the present specification may also be applied to a configuration other than NAND flash memory, such as three-dimensional type NOR flash memory, for example. Moreover, technology described in the present specification may also be applied to a configuration other than flash memory, such as three-dimensional type DRAM, for example.

### [Others]

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor memory device comprising:
a first chip (C_{M}) which comprises a plurality of memory blocks (BLK) that are arranged in a first direction (Y-direction) and extend in a second direction (X-direction) intersecting the first direction (Y-direction); and
a second chip (C_{P}) which is bonded to the first chip (C_{M}) via a bonding electrode (P₁₁, P₁₂), wherein
the plurality of memory blocks (BLK) each comprise:
a plurality of word line conductive layers (110(WL)) stacked in a stacking direction (Z-direction);
a semiconductor column (120) which extends in the stacking direction (Z-direction) and faces the plurality of word line conductive layers (110(WL)); and
an electric charge accumulating film (132) provided between the plurality of word line conductive layers (110(WL)) and the semiconductor column (120),
the second chip (C_{P}) comprises:
a semiconductor substrate (200);
a plurality of transistor groups which are provided on the semiconductor substrate (200) correspondingly to the plurality of memory blocks (BLK), are arranged in the first direction (Y-direction), and each include a plurality of transistors (Tr) arranged in the second direction (X-direction);
a block decoder (BLKD) which is provided on the semiconductor substrate (200), and decodes a block address to select one of the plurality of memory blocks (BLK);
a first wiring layer (D3) provided between the semiconductor substrate (200) and the first chip (C_{M}); and
a second wiring layer (D4) provided between the first wiring layer (D3) and the first chip (C_{M}),
the second wiring layer (D4) comprises a plurality of word line voltage supply line groups (CGG) and a plurality of block select line groups (BLKSELG) that are arranged alternately in the second direction (X-direction),
the plurality of word line voltage supply line groups (CGG) each comprise a plurality of word line voltage supply lines (CGI) which extend in the first direction (Y-direction) and are arranged in the second direction (X-direction),
the plurality of word line voltage supply lines (CGI) are each commonly electrically connected to corresponding ones of the plurality of word line conductive layers (110 (WL)) included in each of the plurality of memory blocks (BLK), via a corresponding one of the plurality of transistors (Tr) included in each of the plurality of transistor groups,
the plurality of block select line groups (BLKSELG) each comprise a plurality of block select lines (BLKSEL) which extend in the first direction (Y-direction) from a position in the first direction (Y-direction) corresponding to the block decoder (BLKD) to a position in the first direction (Y-direction) corresponding to a corresponding one of the plurality of transistor groups, and are arranged in the second direction (X-direction),
the plurality of block select lines (BLKSEL) are each commonly electrically connected to gate electrodes of n transistors included in a corresponding one of the plurality of transistor groups,
the plurality of block select line groups (BLKSELG) each include a first block select line (BLKSEL) and a second block select line (BLKSEL),
the first block select line (BLKSEL), which is a first block select line (BLKSEL) counting from one side in the second direction (X-direction), of the plurality of block select lines (BLKSEL), comprises a first bent portion (402) where the first block select line (BLKSEL) is bent in a direction of getting further away from the word line voltage supply line (CGI) adjacent in the second direction (X-direction),
the second block select line (BLKSEL) comprises a first connecting portion (401) which is electrically connected at its end portion in the first direction (Y-direction) to the first wiring layer (D3), and
positions in the first direction (Y-direction) of the first bent portions (402) in each of the plurality of block select line groups (BLKSELG) differ from each other.

2. The semiconductor memory device according to claim 1, wherein
in each of the plurality of block select line groups (BLKSELG), the position in the first direction (Y-direction) of the first bent portion (402) is on an opposite side to the block decoder (BLKD), viewed from a position in the first direction (Y-direction) of the first connecting portion (401).

3. The semiconductor memory device according to claim 1, wherein
the plurality of block select line groups (BLKSELG) each include a third block select line (BLKSEL) and a fourth block select line (BLKSEL),
the third block select line (BLKSEL), which is a first block select line (BLKSEL) counting from the other side in the second direction (X-direction), of the plurality of block select lines (BLKSEL), comprises a second bent portion (402) where the third block select line (BLKSEL) is bent in a direction of getting further away from the word line voltage supply line (CGI) adjacent in the second direction (X-direction),
the fourth block select line (BLKSEL) comprises a second connecting portion (401) which is electrically connected at its end portion in the first direction (Y-direction) to the first wiring layer (D3) and whose position in the first direction (Y-direction) differs from a position in the first direction (Y-direction) of the first connecting portion (401), and
positions in the first direction (Y-direction) of the first bent portions (402) and the second bent portions (402) in each of the plurality of block select line groups (BLKSELG) differ from each other.

4. The semiconductor memory device according to claim 1, wherein
the first connecting portion (401) is electrically connected at its end portion in the first direction (Y-direction) to the first wiring layer (D3) via each of two contacts.

5. The semiconductor memory device according to claim 1, wherein
the first connecting portion (401) is at a position that does not overlap the bonding electrode (P11, P12), viewed in the stacking direction (Z-direction).

6. The semiconductor memory device according to claim 5, wherein
the first connecting portion (401) is disposed in a hookup wiring region (R_{WLH}).

7. The semiconductor memory device according to claim 1, wherein
the plurality of block select line groups (BLKSELG) each include a fifth block select line (BLKSEL) and a first power supply line (501, 502),
the fifth block select line (BLKSEL) comprises a third connecting portion (401) which is electrically connected at its end portion in the first direction (Y-direction) to the first wiring layer (D3) and whose position in the first direction (Y-direction) differs from a position in the first direction (Y-direction) of the first connecting portion (401),
the first block select line (BLKSEL) further comprises a third bent portion (402) where the first block select line (BLKSEL) is bent in a direction of getting further away from the word line voltage supply line (CGI) adjacent in the second direction (X-direction), and
the first power supply line (501, 502) is provided on an opposite side to the block decoder (BLKD) viewed in a position in the first direction (Y-direction) of the third bent portion (402), and extends in the first direction (Y-direction) at a position in the second direction (X-direction) of a portion provided between the first bent portion (402) and the third bent portion (402), of the first block select line (BLKSEL).

8. The semiconductor memory device according to claim 7, wherein
the plurality of block select line groups (BLKSELG) each include a third block select line (BLKSEL), a fourth block select line (BLKSEL), a sixth block select line (BLKSEL), and a second power supply line (501),
the third block select line (BLKSEL), which is a first block select line (BLKSEL) counting from the other side in the second direction (X-direction), of the plurality of block select lines (BLKSEL), comprises: a second bent portion (402) where the third block select line (BLKSEL) is bent in a direction of getting further away from the word line voltage supply line (CGI) adjacent in the second direction (X-direction); and a fourth bent portion (402) where the third block select line (BLKSEL) is bent in a direction of getting even further away from the word line voltage supply line (CGI) adjacent in the second direction (X-direction),
the fourth block select line (BLKSEL) comprises a second connecting portion (401) which is electrically connected at its end portion in the first direction (Y-direction) to the first wiring layer (D3) and whose position in the first direction (Y-direction) differs from positions in the first direction (Y-direction) of the first connecting portion (401) and the third connecting portion (401),
the sixth block select line (BLKSEL) comprises a fourth connecting portion (401) which is electrically connected at its end portion in the first direction (Y-direction) to the first wiring layer (D3) and whose position in the first direction (Y-direction) differs from positions in the first direction (Y-direction) of the first connecting portion (401), the second connecting portion (401), and the third connecting portion (401), and
the second power supply line (501) is provided on an opposite side to the block decoder (BLKD) viewed in a position in the first direction (Y-direction) of the fourth bent portion (402), and extends in the first direction (Y-direction) at a position in the second direction (X-direction) of a portion provided between the second bent portion (402) and the fourth bent portion (402), of the third block select line (BLKSEL).

9. The semiconductor memory device according to claim 1, wherein
the plurality of word line voltage supply line groups (CGG) each include two word line voltage supply lines (CGI).

10. The semiconductor memory device according to claim 1, wherein
the plurality of word line voltage supply line groups (CGG) each include four word line voltage supply lines (CGI).
